(19) Europäisches Patentamt
European Patent Office
Office européen des brevets

(11) **EP 1 598 818 B1**

(12) **EUROPEAN PATENT SPECIFICATION**

(45) Date of publication and mention
of the grant of the patent:
**25.06.2008 Bulletin 2008/26**

(51) Int Cl.:
***G11B 7/24*** *(2006.01)*          ***G11B 7/26*** *(2006.01)*

(21) Application number: **05010505.5**

(22) Date of filing: **13.05.2005**

(54) **Optical recording medium, manufacturing method of the same, and sputtering target**

Optisches Aufzeichnungsmedium, Verfahren zur Herstellung desselben und Zerstäubungstarget

Support d'enregistrement optique, méthode de fabrication du même et cible de pulverisation

(84) Designated Contracting States:
**DE ES FR GB IT NL**

(30) Priority: **17.05.2004 JP 2004146200**
**29.11.2004 JP 2004344215**

(43) Date of publication of application:
**23.11.2005 Bulletin 2005/47**

(73) Proprietor: **Ricoh Company, Ltd.**
**Tokyo 143-8555 (JP)**

(72) Inventors:
• **Kibe, Takeshi**
**Ohta-ku,**
**Tokyo 143-8555 (JP)**
• **Yamada, Katsuyuki**
**Ohta-ku,**
**Tokyo 143-8555 (JP)**

• **Shinkai, Masaru**
**Ohta-ku,**
**Tokyo 143-8555 (JP)**
• **Narumi, Shinya**
**Ohta-ku,**
**Tokyo 143-8555 (JP)**
• **Shinotsuka, Michiaki**
**Ohta-ku,**
**Tokyo 143-8555 (JP)**
• **Iwasa, Hiroyuki**
**Ohta-ku,**
**Tokyo 143-8555 (JP)**

(74) Representative: **Barz, Peter**
**Kaiserplatz 2**
**80803 München (DE)**

(56) References cited:
**EP-A- 1 280 142          EP-A- 1 406 254**
**US-A1- 2003 003 395**

Description

## BACKGROUND OF THE INVENTION

### Field of the Invention

The present invention relates to optical recording media such as MOs, PDs, CD-Rs, CD-RWs, DVD-Rs, DVD-RWs, DVD+Rs, DVD+RWs, DVD-RAMs and Blue-ray discs, which are capable of high-speed recording by irradiation of a laser beam and particularly relates to optical recording media having a large storage capacity and a high recording density not less than those of DVD-ROMs. The present invention further relates to optical recording media having an extremely large storage capacity by having at least two recording layers.

### Discussion of the Background

The basic layer structures of optical recording media are typified into a write-once type and a rewritable type. Write-once optical recording media have a layer structure of a substrate, a dye recording layer and an optical reflective layer. Rewritable optical recording media have a layer structure of a substrate, a bottom protective layer, an optical recording layer, a top protective layer and an optical reflective layer. Further, an intermediate layer is provided between the bottom protective layer and the optical recording layer, the optical recording layer and the top protective layer and/or the top protective layer and the optical reflective layer on a necessity basis.

Recently, optical recording media having a higher recording density and a higher linear recording velocity have been expected to record more information at a higher linear velocity. As a solution to these demands, adoption of an optical reflective layer containing Ag has now been discussed.

<Related art of optical reflective layer containing Ag>

The following merits are expected when Ag is used in the optical reflective layer of an optical recording medium.

(1) Playback performance can be improved as a result of an increase in disc reflectivity in a broad wavelength range.
(2) Playback performance can be improved as a result of an increase in signal amplitude due to the optical characteristics of Ag.
(3) Overwriting performance can be improved because a recording medium can have a layer structure having a relatively fast cooling down speed when the recording medium to which an optical reflective layer is provided is a phase change type optical recording medium.
(4) Recordable linear velocity range can be widened because a recording medium can have a layer structure having a relatively fast cooling down speed when the recording medium to which an optical reflective layer is provided is a phase change type optical recording medium.
(5) Productivity can be improved due to a high sputtering efficiency.
(6) Thermal stress can be reduced because the time to be taken to form a film by sputtering is shortened, i.e., mechanical property of the disc is improved.

To secure these merits of using Ag, it is preferred that an optical reflective layer containing Ag in an amount not less than 95 atomic % is used. It is further preferred that an optical reflective layer containing Ag in an amount not less than 97 atomic % is used

However, there are following drawbacks when Ag is utilized in the optical reflective layer of an optical recording medium.

(1) Easily corroded in a high temperature and high humid environment.
(2) Easily corroded by sulfur and chlorine.
(3) Having a weak cohesiveness with a substrate.
(4) The crystal particle diameter of Ag increases in a high temperature and high humid environment.
(5) The crystal particle diameter of Ag tends to increase, which is a cause of noises for playback signals when high density recording is performed.
(6) Properties of optical recording media are easily influenced by changes in its production process.

To restrain corrosion of Ag, alloyed Ag is used. Published unexamined Japanese Patent Application No. (hereinafter referred to as JOP) S57-186244 discloses AgCu. JOP H7-3363 discloses AgMg. JOP H9-156224 discloses AgOM, in which M represents Sb, Pd, or Pt. JOP 2000-285517 discloses AgPdCu. JOP H6-243509 discloses AgIn, AgV and AgNb. In addition, Japanese Patent No. (hereinafter referred to as JP) 2749080 discloses metals in which one of or a combination of Ti, V, Fe, Co, Ni, Zn, Zr, Nb, Mo, Rh, Pd, Sn, Sb, Te, W, Ir, Pt, Pb, Bi and C are contained in Ag to control thermal conductivity of an optical reflective layer.

However, when these materials are actually used in an optical reflective layer to prepare DVD+R discs and DVD+RW discs and these optical discs are evaluated for archival high temperature preservation reliability at 80°C and 85% relative humidity (here and throughout the specification abbreviated as RH), the number of errors for the discs drastically increases when the discs are preserved for 300 hours. Conclusively, preservation reliability of these discs is not sufficient.

Conventionally, an ultraviolet curing resin layer is formed on a reflective layer to prevent corrosion of a reflective layer. For example, JOP 2001-222842 discloses a teaching to prevent corrosion of an Al containing reflective layer by using an ultraviolet curing resin layer having a glass transition temperature not lower than 45 °C, thereby preventing formation of wrinkles caused by water absorption of the resin. However, when the inventors of the present invention performed an experiment for the resin having a glass transition temperature of 80 °C disclosed in JOP 2001-222842, corrosion was observed and playback error increased when an Ag containing optical reflective layer was used.

<Related art for dielectric layer>

The following technologies are known for inorganic protective layer (dielectric layer) for use in an optical recording medium, especially a phase change type optical recording medium.

JOP 52-2783 discloses a top protective layer containing various kinds of materials such as oxides, sulfides, selenium containing compounds and fluoride of metals or half metals to avoid thermal transformation or evaporation caused by heating an optical recording layer. Further, to secure the mechanical strength and weather resistance of a top protective layer, JOP 52-2783 also discloses accumulation of an organic protective layer formed of, for example, a methacrylic acid resin, on the top protective layer.

JOP 4-61791 discloses a phase change type optical recording medium having a basic structure of a substrate, a bottom protective layer, an optical recording layer, a top protective layer and an optical reflective layer. The bottom protective layer and the top protective layer are formed to prevent diffusion of the optical recording layer and the optical reflective layer is formed for optical enhancement effect. In addition, JOP 4-61791 discloses a top protective layer having a thickness of from 1 to 50 nm containing various kinds of materials such as oxides, sulfides, selenium containing compounds, fluoride and nitride of metals or half metals or C. Further, JOP 4-61791 also discloses a bottom protective layer using the same material as those for use in the top protective layer.

JOP 60-179953 discloses a top protective layer using materials such as oxides, fluoride and nitride of metals or half metals for the purpose of having high sensitivity and long life.

JOP 5-45434 discloses a bottom protective layer using $GeO_x$ by which the refraction index thereof is relatively low in comparison with that of an optical recording layer and describes that the sensitivity is improved and the heat damage to a substrate is reduced through utilization of optical coherence effect.

In JOP 6-87320, the following requirements are described for top and bottom protective layers: 1) transparent in the target wave length range, 2) having a relatively high melting point and 3) no cracking. Therefore, as top and bottom protective layers satisfying these requirements, instead of using a conventional material such as $GeO_2$ and $SiO_2$, top and bottom protective layers using ZnS, ZnSe and ZnTe are proposed to secure high temperature preservability against approximately 2,000 °C and to have a refractive ratio relatively large in comparison with that of a substrate to improve the absorption ratio by the effect of optical coherency.

In JOPs 4-74785 and 6-90808, the requirements for top and bottom protective layers are described as follows: 1) transparent in the target wave length range, 2) having a relatively high melting point in comparison with the temperature during action, 3) having a strong mechanical strength, 4) chemically stable, and 5) having appropriate thermal indices (i.e., thermal conductivity, specific heat). Therefore, as top and bottom protective layers satisfying these requirements, top and bottom protective layers using a mixture of crystalline chalcogenized compounds such as ZnS, ZnSe and ZnTe and a glass substance such as $SiO_2$, $GeO_2$, $SnO_2$, $In_2O_3$ and $TeO_2$ are proposed. Further, it is described in JOPs 4-74785 and 6-90808 that, when the glass substance is contained in an amount of approximately 20 mol % based on such a mixture, the recording power is reduced, resulting in reduction of heat damage, which leads to improvement of overwriting performance.

JOP 7-114031 discloses that a mixture of ZnS and $SiO_x$ (x is from 1 to 1.8) is used for top and bottom protective layers. It is described therein that thermal conductivity of the layers is reduced, resulting in improvement of the sensitivity thereof when compared with that of a mixture of ZnS and $SiO_2$, and thermal impact resistivity based on internal stress reduction caused by particle boundary relaxation of Si and $SiO_2$ can be improved, resulting in improvement of overwriting performance.

JP 2511964 discloses that, when the layers sandwiching a recording layer are a combination of a protective layer formed of a material such as $ZrO_2$ and $SiO_2$ having a low thermal conductivity and a protective layer having a large thermal conductivity, it is effective to reduce tracking noise.

JP 2915112 discloses a ZnS-SiO$_2$ based protective layer containing a mixture of a material selected from the group consisting of ZnS, ZnSe, CdS, CdSe and InS and a material selected from the group consisting of Ta$_2$O$_5$, Cu$_2$O, WO$_3$, MoO$_3$, CeO$_2$, La$_2$O$_3$ and SiO to improve the reliability of the protective layer in a high temperature and high humidity environment, i.e., at 80 °C and 95% RH and to have a thermal expansion index closer to that of a recording layer.

JP 2788395 discloses a bottom protective layer containing ZnS and SiO$_2$ (not greater than 25 mol %) and a top protective layer containing ZnS and SiO$_2$ (not less than 25 mol %) to secure the reliability in a high temperature and high humidity environment and improve overwrite performance and recording sensitivity.

JOP 5-62244 discloses a top protective layer containing Al$_2$O$_3$, Ta$_2$O$_5$, AlN, Si$_3$N$_4$ and ZnS, and a reflective layer containing Au, Ag and Al to have a rapid cooling down structure by optimizing film thickness of the top protective layer and the reflective layer.

JOP 5-151619 discloses a top protective layer containing a material such as BN, AlN and SiC having a large thermal conductivity to obtain a rapid cooling down structure of an optical recording medium.

JOP 2002-352472 discloses a top protective layer containing a material such as oxides of Ta and nitrides of Ta having a large thermal conductivity and an optical reflective layer containing a material such as Ag having a large thermal conductivity.

JOP 8-27980 discloses barrier layers formed of SiO$_2$, Al$_2$O$_3$ and MgO sandwiching an optical recording layer to restrain alternation caused by chemical reaction and alloying between the optical recording layer and the bottom protective layer and the optical recording layer and the top protective layer.

As described above, various kinds of materials for use in bottom and top protective layers and layer structures have been developed. As a result, a rapid cooling down structure having a substrate, a bottom protective layer, an optical recording layer, a top protective layer, an optical reflective layer and a resin layer is currently adopted as a practical layer structure for a phase change type optical recording medium having a single optical recording layer. Further, an intermediate layer is provided between a bottom protective layer and an optical recording layer, an optical recording layer and a top protective layer, and a top protective layer and an optical reflective layer if necessary. Practical thickness of each layer thickness is from 50 to 120 nm for a bottom protective layer, from 10 to 20 nm for a bottom protective layer, from 10 to 20 nm for a recording layer, from 7 to 40 nm for a top protective layer, from 120 to 200 nm for an optical reflective layer and from 2 to 8 nm for an intermediate layer. Specific practical materials for each layer include ZnS·SiO$_2$ (20 mol %) for a bottom and top protective layers, GeSbTe, AgInSbTe and GeInSbTe for a recording layer, AlTi, AlTa, Ag, AgPdCu and AgNdCu for a reflective layer, and GeN, GeCr, Si, SiC, Ta$_2$O$_5$ and Al$_2$O$_3$ for an intermediate layer.

<Related art for a barrier layer (intermediate layer)>

Typically, a film formed of ZnS·SiO$_2$ (20 mol %) is used for forming the bottom protective layer and the top protective layer of a phase change type optical recording medium. This material has a thermal expansion coefficient, optical constants and an elasticity ratio suitable for a phase change type optical recording medium. However, when an optical reflective layer containing Ag is used for high speed recording in a phase change type optical recording medium and directly formed on ZnS·SiO$_2$, it is known that Ag reacts with S in ZnS·SiO$_2$, resulting in corrosion of the reflective layer.

As a countermeasure for this drawback, JOP 11-238253 discloses an intermediate layer using metals such as Ta, Ni, Co, Cr, Si, W and V, semiconductors, and their oxides, nitrides and carbides and amorphous carbon to inhibit chemical reaction between S atoms in a protective layer in a phase change type optical recording medium and Ag atoms in an optical reflective layer containing Ag. The thickness of such an intermediate layer is from 1 to 100 nm and preferably from 5 to 50 nm. However, materials specified therein other than metals are silicon oxides, silicon nitrides, silicon carbides, tantalum oxide, cerium oxides, lanthanum oxides and yttrium oxides and the only example shown therein is Ta$_2$O$_5$ having a thickness of from 10 to 50 nm. Among these, silicon carbide (SiC) is a material which is used in Comparative Example of this specification and carbides of Ti, Nb and Ta, and material containing carbon and/or oxygen, which are used in the present invention, are not described in JOP 11-238253 at all. In addition, there is no mention about improvement of cohesion property between an optical reflective layer containing Ag and its adjacent layers, which is an object of the present invention.

Further, the inventors of the present invention manufactured a phase change type optical recording medium including an intermediate layer formed of the materials mentioned above and found that, when the intermediate layer had a thickness of from 10 to 50 nm, the quality of signals obtained did not reach a practical level because the signal quality greatly depended on the intermediate layer thickness. In addition, a heat cycle test was preformed. The cycle was 24 hours including 9 hours of 25 °C and 95 %RH, 3 hours of temperature rising at a rate of 5 °C/hour, 9 hours of 40 °C and 95 %RH and 3 hours of temperature falling at a rate of -5 °C/hour and repeated 6 times in the test. A drawback occurred in that the optical reflective layer containing Ag was detached from the intermediate layer.

That is, as a result of the study by the inventors of the present invention, it is found that, although the intermediate layer can inhibit the reaction between sulfur contained in the protective layer and Ag, the cohesion between the intermediate layer and the optical reflective layer containing Ag is not sufficient so that the cohesion between both layers deteriorates in a high humidity environment and by condensation. This is thought to be that corrosion of an optical reflective layer containing Ag is inhibited by a chemically inactive intermediate layer provided to restrain mutual diffusion but thereby cohesion of the intermediate layer and the optical reflective layer containing Ag deteriorates, especially under a high humidity condition.

In addition, the inventors of the present invention have tried to use the metals of materials mentioned above in a form of a thin film having a thickness not thicker than 4 nm. It was found that metals such as Ti, Nb and Ta had too fast sputtering speed to control its thickness. Therefore, these metals are not suitable in terms of production. In contrast, it was found that Ti oxides, Nb oxides and Ta oxides had too slow sputtering speed. Therefore, these oxides are not suitable in terms of productivity.

In addition, DC sputtering is impossible for dielectric substances such as Ti oxides, Nb oxides and Ta oxides, resulting in increase of the cost. Thus these dielectrics are not suitable for production. Further, the cost of Ta and Ta oxides are high, resulting in loss of competitive edge in the market.

JOP 2002-74746 discloses that a barrier layer containing nitrides, oxides, carbides or nitride oxides of element $\alpha$, wherein $\alpha$ represents at least one element of Sn, In, Zr, Si, Cr, Al, Ta, V, Nb, Mo, W, Ti, Mg and Ge, is provided between a dielectric layer and a reflective layer. However, the material described is only Ge-Cr-N, meaning that there is no specific suggestion or mention about materials containing carbides or carbide oxides of Ti, Nb and Ta, which selectively show excellent effects in the present invention. Furthermore, there is no description about improvement of cohesion between an optical reflective layer and its adjacent layers, which is an issue of the present invention.

JOPs 10-275360 and 2002-203338 disclose an intermediate layer using GeN, GeCrN and SiC functioning as a sulfuration protection layer for an optical reflective layer containing Ag or Ag alloy.

JOP 2002-203338, which is applied for by inventors of the present invention, discloses an intermediate layer containing nitrides, oxides and carbides of a various kinds of metals and semi metals. The intermediate layer therein preferably has a thickness of 10 nm.

JOP 2000-331378 discloses a top protective layer which is in contact with a reflective heat release layer. The top protective layer contains AlN, $SiN_x$, SiAlN, TiN, BN, TaN, $Al_2O_3$, MGO, SiO, $TiO_2$, $B_2O_3$, $CeO_2$, CaO, $Ta_2O_5$, ZnO, $In_2O_3$, $SnO_2$, WC, MoC, TiC and SiC and can be multiple layered. In addition, the top protective layer has a thickness of from 7 to 60 nm and preferably from 10 to 30 nm in total. JOP 2004-185794, which is also applied for by inventors of the present invention, discloses a structure in which a layer formed of a mixture of a carbide and an oxide of a metal selected from the group consisting of Ti, Zr, V, Nb, Ta, Cr, Mo and W is provided between an optical reflective layer containing Ag and $ZnS \cdot SiO_2$. Thereby, corrosion of the optical reflective layer containing Ag can be restrained. Actually, it has been confirmed that the layer is effective as an intermediate layer for a $2.4\times$ DVD + RW disc.

However, when the same intermediate layer is applied to a $4\times$ DVD+RW disc, the same effect is not obtained. The inventors of the present invention have analyzed this result and found that, although crystallization treatment (i.e., initialization) of a recording layer is necessary to be sped up with a high power as a recording linear velocity increases, the cohesion strength between an optical reflective layer containing Ag and an intermediate layer is not strong enough to bear this severe initialization condition. In addition, another possible cause was that the cohesion strength varies depending on variance in various kinds of the production processes. Further, it has also been inferred that, when recording is performed at a high speed with a high power in a short time, thermal stress on an optical recording medium increases, which has an impact on preservation reliability.

Also, it is found that the condition of forming an intermediate layer provided between a ZnS • $SiO_2$ layer and an optical reflective layer containing Ag or Ag alloy has a great impact on reaction properties between Ag and S. Especially there is a problem in that oxygen and vapor remaining in a layer while the layer is formed by sputtering causes deterioration of the quality of the layer, which leads to deterioration of passivation ability. It is also found that when a pressure of remaining oxygen is large during forming an intermediate layer, the optical reflective layer containing Ag and Ag alloy is corroded. As mentioned above, the passivation ability of an intermediate layer depends on conditions of layer forming. Therefore, a rigid control of manufacturing processes is necessary, but in reality, perfect control is not easy.

Furthermore, when it takes not less than 5 minutes from a substrate molding process to a sputtering layer forming process, cohesion strength between the optical reflective layer containing Ag and the intermediate layer deteriorates. Similarly, when it takes more than one day from a puttering layer forming process to an initialization process (i.e., crystallization treatment of a recording layer), cohesion strength between an optical reflective layer containing Ag and an intermediate layer deteriorates.

As mentioned above, in reality, it has become impossible to stably manufacture phase change type optical recording media in which high density recording can be performed well at a high speed, i.e., 4x and higher for a DVD, with conventional materials and layer structures for an optical recording medium.

Because of these reasons, a need exists for an optical recording medium in which information can be recorded at a high speed with a high density and which can be stably manufactured without degrading the quality thereof.

EP 1 406 254 A2 discloses an optical recording medium comprising a substrate, a lower protective layer, a recording layer, an upper protective layer and a reflective layer. When the reflective layer comprises Ag and the upper protective layer comprises ZnS and $SiO_2$, a sulfuration-inhibiting layer must be arranged between the upper protective layer and the reflective layer to thereby avoid sulfuration of Ag by sulfur. Examples for the materials for the sulfuration-inhibition layer are amongst others SiC, TiC, and other carbides.

## SUMMARY OF THE INVENTION

Accordingly, an object of the present invention is to provide an optical recording medium which has a good preservation reliability under a high temperature and high humidity environment, shows a stable performance at a high temperature, has good mechanical characteristics with good productivity and can optically record information with a high speed and a high density, and further relates to a method of manufacturing such an optical recording medium. In addition, another object of the present invention is to provide a sputtering target for such an optical recording medium.

Briefly these objects and other objects of the present invention, as hereinafter will become more readily apparent, can be attained by an optical recording medium including a substrate, a bottom protective layer located overlying the substrate, an optical recording layer located overlying the bottom protective layer, a top protective layer located overlying the optical recording layer, an intermediate layer located overlying the top protective layer containing carbon, oxygen and at least one element selected from the group consisting of Ti, Nb and Ta, and an optical reflective layer containing Ag in an amount not less than 95 atomic %, located overlying the intermediate layer. In addition, the optical recording medium is recordable even in one of the following recording conditions (1) to (3) : (1) when the recording time for the shortest recording mark is not greater than 34 ns; (2) when the recording time of a channel bit length is not greater than 11 ns; and (3) when the recording linear velocity is not less than 11 m/s.

It is still further preferred that the intermediate layer comprises at least one of chemical linkages of (M) and carbon and (M) and oxygen.

It is still further preferred that the intermediate layer contains one combination selected from the group consisting of (A) Ti, C and O, (B) Nb, C and O, and (C) Ta, C and O. The composition ratios of Ti, C and O in (A) satisfy the following relationship: $37 \leq \alpha 1 \leq 48$, $12 \leq \beta 1 \leq 45$, $7 \leq \gamma 1 \leq 51$, $\alpha_1 + \beta_1 + \gamma_1 = 100$, wherein $\alpha_1$, $\beta_1$ and $\gamma_1$ represent a composition ratio by atomic % of Ti, C and O, respectively. The composition ratio of Nb, C and O in (B) satisfy the following relationship: $33 \leq \alpha_2 \leq 47$, $9 \leq \beta_2 \leq 43$, $10 \leq \gamma_2 \leq 58$,

$\alpha_2 + \beta_2 + \gamma_2 = 100$, wherein $\alpha_2$, $\beta_2$ and $\gamma_2$ represent a composition ratio by atomic % of Nb, C and O, respectively. The composition ratio of Ta, C and O in (C) satisfy the following relationships: $32 \leq \alpha_3 \leq 47$, $9 \leq \beta_3 \leq 43$, $10 \leq \gamma_3 \leq 59$, $\alpha_3 + \beta_3 + \gamma_3 = 100$, wherein $\alpha_3$, $\beta_3$ and $\gamma_3$ represent a composition ratio by atomic % of Ta, C and O, respectively.

It is still further preferred that the intermediate layer has a thickness of from 1 to 9 nm.

It is still further preferred that the top protective layer comprises ZnS and $SiO_2$.

It is still further preferred that the recording layer contains an alloyed metal selected from the group consisting of a structural formula (A) represented by $Ag_\alpha Ge_\beta In_\gamma Sb_\delta Te_\varepsilon$ and a structural formula (B) having a structural formula represented by $Ga_{\alpha'1} In_{\alpha'2} Ge_{\beta'} Sb_{\gamma'} Sn_\delta, Bi_{\varepsilon'} Te_{\varepsilon'2}$, wherein the structural formula (A) satisfies the following relationships: $0 \leq \alpha \leq 5$; $0 \leq \beta \leq 5$; $2 \leq \gamma \leq 10$; $60 \leq \delta \leq 90$; $15 \leq \varepsilon \leq 30$; and $\alpha + \beta + \gamma + \delta + \varepsilon = 100$, wherein $\alpha$, $\beta$, $\gamma$, $\delta$ and $\varepsilon$ represent atomic %. The structural formula (B) satisfies the following relationships: $0 \leq \alpha'1 \leq 20$; $0 \leq \alpha'2 \leq 20$; $2 \leq \alpha'1 + \alpha'2 \leq 20$; $2 \leq \beta' \leq 20$; $60 \leq \gamma' \leq 90$; $5 \leq \delta' \leq 25$; $0 \leq \varepsilon'1 \leq 10$; $0 \leq \varepsilon'2 \leq 10$; $0 \leq \varepsilon'1 + \varepsilon'2 \leq 10$, and $\alpha'1 + \alpha'2 + \beta' + \gamma' + \delta' + \varepsilon'1 + \varepsilon'2 = 100$, wherein $\alpha'1$, $\alpha'2$, $\beta'$, $\gamma'$, $\delta'$, $\varepsilon'1$ and $\varepsilon'2$ represent atomic %.

It is still further preferred that the optical recording medium is recyclable for use by irradiating the optical recording layer with a semiconductor laser beam for re-crystallization of the optical recording medium.

As another aspect of the present invention, a method of checking the optical recording medium mentioned above, is provided, which includes storing an optical recording medium at 85% RH and 80° C before initially crystallizing the optical recording medium, initially crystallizing the optical recording medium, and randomly inspecting the optical recording medium in the manufacturing process thereof for its appearance, the number of errors and defect ratio to evaluate quality of the optical recording medium and quality of the manufacturing process of the optical recording medium.

As another aspect of the present invention, a sputtering target for forming an intermediate layer of an optical recording medium is provided which contains one combination selected from the group consisting of (A) TiC and $TiO_2$, (B) NbC and $Nb_2O_5$, and (C) TaC and $Ta_2O_5$. The composition ratios of Ti, C and O in (A) satisfy the following relationship: $37 \leq \alpha_1 \leq 48$, $12 \leq \beta_1 \leq 45$, $7 \leq \gamma_1 \leq 51$, $\alpha_1 + \beta_1 + \gamma_1 = 100$, wherein $\alpha_1$, $\beta_1$ and $\gamma_1$ represent a composition ratio by atomic % of Ti, C and O, respectively. The composition ratios of Nb, C and O in (B) satisfy the following relationship: $33 \leq \alpha_2 \leq 47$, $9 \leq \beta_2 \leq 43$, $10 \leq \gamma_2 \leq 58$, $\alpha_2 + \beta_2 + \gamma_2 = 100$, wherein $\alpha_2$, $\beta_2$ and $\gamma_2$ represent a composition ratio by atomic % of Nb, C and O, respectively. In addition, the composition ratios of Ta, C and O in (C) satisfy the following relationships: $32 \leq \alpha_3 \leq 47$, $9 \leq \beta_3 \leq 43$, $10 \leq \gamma_3 \leq 59$, $\alpha_3 + \beta_3 + \gamma_3 = 100$, wherein $\alpha_3$, $\beta_3$ and $\gamma_3$ represent a composition ratio by atomic % of Ta, C and O, respectively.

These and other objects, features and advantages of the present invention will become apparent upon consideration of the following description of the preferred embodiments of the present invention taken in conjunction with the accompanying drawings.

## BRIEF DESCRIPTION OF THE DRAWINGS

Various other objects, features and attendant advantages of the present invention will be more fully appreciated as the same becomes better understood from the detailed description when considered in connection with the accompanying drawings in which like reference characters designate like corresponding parts throughout and wherein:

Fig. 1 is a diagram illustrating an irradiation pattern for an optical recording medium and a recorded mark;
Fig. 2 is a diagram illustrating the layer structure of the optical recording medium of the present invention; and
Fig. 3 is a graph illustrating the progress of the defect ratio of the optical discs of Examples 4 to 6 and Comparative Examples 3 and 4 in a high temperature and high humidity environment.

## DETAILED DESCRIPTION OF THE INVENTION

The present invention will be described below in detail with reference to several embodiments and accompanying drawings.

As a result of an intensive study on a conventional optical recording medium including an optical reflective layer containing Ag, it is found that main issues therefor are caused by the following (a) to (d).

(a) cohesion strength between an optical reflective layer containing Ag and its underlying layer;
(b) weather resistance of an optical reflective layer containing Ag;
(C) aggregation of crystal particles of an optical reflective layer containing Ag; and
(d) crystal particle diameter of an optical reflective layer containing Ag.

The concrete issue of (a) mentioned above is that, in the case of an optical recording medium such as a DVD +R having a dye recording layer, since cohesion strength between the dye and the optical reflective layer containing Ag is not sufficient, the recorded portion which has been thermally damaged by optical recording is resultantly transformed, which leads to shortening of preservation life of the medium. This phenomenon is significant in the case of an optical recording medium for high speed recording (i.e., not less than 10x for CD-Rs and CD-RWs, meaning 12 m/s recording linear velocity and not less than $3\times$ for DVD+Rs and DVD+RWs, meaning 10.5 m/s recording velocity). Such an optical recording medium requires optical recording power not less than 20 mW/$\mu$m$^2$ on the disc and it is found that the cohesion strength of an optical reflective layer containing Ag and an undercoat layer deteriorates at such a power level.

The cohesion strength between an optical reflective layer containing Ag and a top protective layer or an intermediate layer located on the top protective layer in a phase change type optical recording medium such as CD-RWs and DVD+RWs is not sufficient. Therefore, when a portion in an amorphous recording state achieved after sputtering layer forming is subject to crystallization treatment (initialization) or is thermally damaged by optical recording, the portion is altered and thus preservation life of the medium is shortened. It is also found that, since an optical recording medium for a high speed recording, meaning not lower than 11 m/s, is especially necessary to be initialized with high speed and high power, the cohesion strength between an optical reflective layer containing Ag and an undercoat layer deteriorates. Therefore, when such an optical recording medium is initialized again, its optical reflective layer containing Ag and undercoat layer detach in some cases. This works to disadvantage when a used phase change type optical recording medium is initialized again for recycle use.

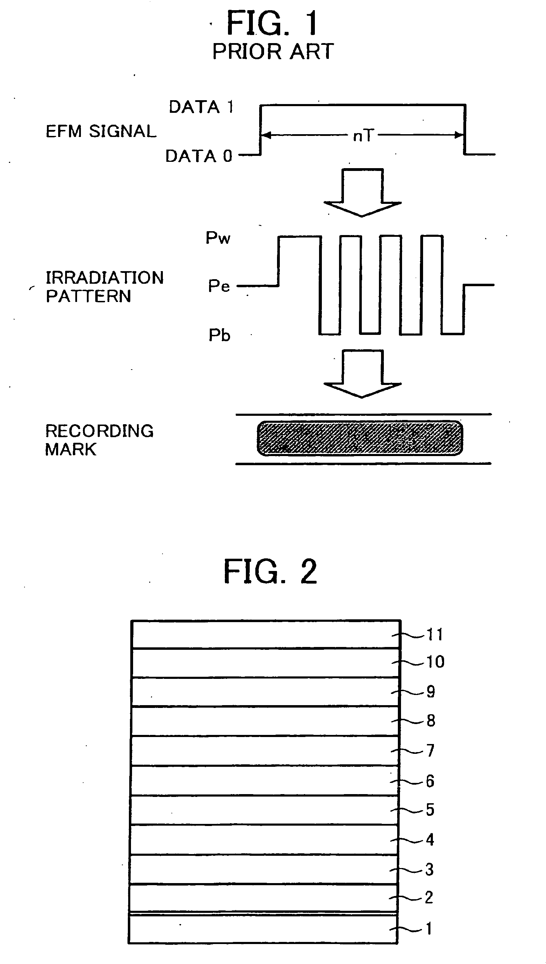

When optical recording is performed using Pulse Width Modulation (PWM) recording (mark edge recording) as in Eight-to-Fourteen Modulation (EFM, 8-14) system typically for use in CDs, an irradiation waveform pattern including multiple pulses having a combination of a recording power Pw and a bottom power Pb as illustrated in Fig. 1 is used. Specific irradiation waveform patterns used are those illustrated in JOP 9-138947, 2001-250230 and 2002-288828.

Recording linear velocity, time to be taken to record the minimum mark, time to be taken to record a channel bit length, time to be taken to record a 1/2 channel bit length (i.e., nearly equal to the time of the minimum irradiation pulse in multiple pulse system) and rectangular property of actual irradiation waveform for a recordable DVD are shown in Table 1. The minimum mark length and the channel bit length correspond to 0.4 $\mu$m and 0.133 $\mu$m for a recordable DVD. The minimum mark length corresponds to approximately 3 times the channel bit length and the longest mark corresponds to approximately 14 times the channel bit length.

In actual high speed optical recording, it takes approximately 2 ns to rise and fall during irradiation. Therefore, in a high speed recording in which irradiation pulse time is short, the rise and fall time occupies relatively large in an irradiation time. If it is the case, it is difficult to obtain a rectangular waveform irradiation. When the rise time occupies not less than 1/3 of the irradiation time in time scale, the recording layer is not rapidly cooled down so that a relatively large recording power is required. Thus, the optical recording medium receives excessive thermal damage or stress, resulting in deterioration of the layer cohesion strength between the optical reflective layer containing Ag and its undercoat layer.

Further, when the rise time occupies not less than 1/2 of the irradiation time in time scale, the irradiation waveform is like a sinusoidal waveform. It is thus impossible to rapidly cool down a recording layer, resulting in impossibility of optical recording.

As illustrated in Fig. 1, in the case of a recordable type DVD in which the minimum irradiation pulse time corresponds to the scanning time of a 1/2 channel bit length, when a recording linear velocity is not less than 11.7 m/s, the recording time of a 1/2 channel bit length is not longer than 6 ns, meaning that the irradiation pulse waveform is away from a rectangular form. When the recording linear velocity is not less than 19.8 m/s, the irradiation waveform is not a rectangular waveform. Optical recording by the minimum irradiation pulse time corresponding to the scanning time for a 1/2 channel bit length is impossible. If it is the case, optical recording by the minimum irradiation pulse time is performed in the scanning time corresponding to a channel bit length. In the case of 8× recording (i.e., 28 m/s) in a DVD, the channel bit length is 5 ns. In this time length, the ratio of the rise time of irradiation reaches the limit. Thus, when DVD recording is performed at 8x or higher, an optical recording corresponding to the scanning time to be taken for the minimum mark length is used.

In addition, in the case of a phase change type optical recording medium performing high speed optical recording, high speed initialization is effective to obtain low jitter. Specifically, it is effective to initialize such a phase change type optical recording medium at a linear velocity not lower than 70 % of the maximum recording linear velocity thereof. The initialization power required to achieve this high speed initialization is high so that thermal stress on the phase change type optical recording medium is large, which leads to deterioration of the layer cohesion strength between the optical reflective layer containing Ag and the intermediate layer.

As described above, when an optical recording medium is capable of recording information at a higher speed, the medium receives more thermal damage and thermal stress and therefore a strong cohesion strength between an optical recording reflective layer and its undercoat layer is necessary. As seen in Table 1, especially (1) when the recording time to be taken for the minimum recording mark is not longer than 34 ns, (2) when the recording time to be taken for a channel bit length is not longer than 11 ns or (3) when the recording linear velocity is not lower than 11 m/s, excessive recording power is required for an optical recording medium. Thus, the cohesion strength between an optical recording reflective layer and its undercoat layer is necessary to be strong.

Table 1

| Recording speed | Linear velocity | Recording time | | | Rectangular Property of irradiation pulse pattern |
|---|---|---|---|---|---|
| | | Minimum mark length (0.4 μm) | Channel bit length (0.133 μm) | 1/2 channel bit length (0.067 μm) | |
| DVD × | m/s | ns | ns | ns | G: channel bit length is longer than 6 ns; F: channel bit length is from 4 to 6 ns; B: channel bit length is shorter than 4 ns |
| 1.0 | 3.5 | 114 | 38 | 19 | G |
| 1.7 | 6.0 | 67 | 22 | 11 | G |
| 2.4 | 8.4 | 48 | 16 | 8 | G |
| 1.7 | 5.8 | 69 | 23 | 11 | G |
| 2.8 | 9.9 | 40 | 13 | 7 | G |
| 4.0 | 14.0 | 29 | 10 | 5 | F |
| 3.3 | 11.7 | 34 | 11 | 6 | F |

(continued)

| Recording speed | Linear velocity | Recording time | | | Rectangular Property of irradiation pulse pattern |
|---|---|---|---|---|---|
| | | Minimum mark length (0.4 $\mu$m) | Channel bit length (0.133 $\mu$m) | 1/2 channel bit length (0.067 $\mu$m) | |
| 5.7 | 19.8 | 20 | 7 | 3 | B |
| 8.0 | 28.0 | 14 | 5 | 2 | B |

The specific issue for (b) mentioned above is an essential issue relating to the material characteristics of an optical reflective layer containing Ag. The issue is that the preservation life of an optical recording medium may be shortened by chemical reaction with corrosive gas such as $H_2S$ and $Cl_2$ and corrosion promoting gas such as vapor existing in use environment and preservation environment of the optical recording medium.
The specific issue of (c) mentioned above is that intrusion of moisture into an optical recording medium promotes aggregation of Ag atoms (ions), thereby producing minute space. This minute space causes a problem when this minute space affects the form of a minute recording mark.

The specific issue of (d) mentioned above is that the particle boundary of crystal forming an optical reflective layer containing Ag causes signal noises during optical recording and playback, resulting in deterioration of optical recording and playback performance of the optical recording medium.

The issues of (c) and (d) are significant problems when high density optical recording is performed using a blue laser beam having a wavelength of around 405 nm.

Furthermore, it is not easy to solve these issues with regard to an optical reflective layer containing Ag and stably mass-produce optical recording media while absorbing various kinds of variances in production processes.

As a result of the further study by the inventors of the present invention, in addition to the issues mentioned above, the following issues (e) to (k) are found in the production process of optical recording media having an optical reflective layer containing Ag.

(e) Amount of water absorption in substrate (preferably not greater than 0.1 g per substrate);
(f) Substrate temperature (preferably not higher than 50 °C);
(g) Sputtering conditions for an optical reflective layer containing Ag (amount of remaining vapor is not greater than 5 x 10-5 mbar) ;
(h) Sputtering conditions for a layer on which an optical reflective layer containing Ag is formed (amount of remaining vapor is not greater than 5 x 10-5 mbar);
(i) Time to be taken to transport a phase change type optical recording medium from after the process of molding a substrate to the process of vacuum layer forming, i.e., time in which moisture in atmosphere is absorbed in a substrate) (preferably within 3 minutes) ;
(j) Air emission time in a load lock portion through which a disc is loaded in and out of a vacuum layer forming device (time to be taken to eliminate moisture absorbed in a substrate) (preferably not shorter than 2 seconds); and
(k) Time to be taken from after forming an optical reflective layer containing Ag to initial crystallization of an optical recording layer (preferably from not longer than 48 hours).

However, when a resin such as polycarbonate is used as a material for a substrate, it is not easy to control the amount of water absorbed in the substrate. Especially, in a factory in which optical recording media are mass-produced, it is extremely difficult to eliminate factors such as extra time taken by suspension or accumulation in disc transportation process in a manufacturing line, abrupt deterioration in air emission efficiency of a vacuum layer forming device, variance in the factory environment (temperature and humidity). In reality, these factors are connected with each other in a complicated manner. It is found that, as the time of (k) increases, defects, such as allochroism, float and detachment of a sputtered layer, tend to occur immediately after the initial crystallization process. It is not necessary but preferred to perform these production processes in these preferred conditions.

The results for (i), (j) and (k) mentioned above are shown in Table 2. The optical recording medium used had the same structure as that of the medium of Example 1 described later. "After 24 hour acceleration" represents after an acceleration test in which an optical recording medium had been preserved for 24 hours in a high temperature and high humidity environment of 80 °C and 85 %RH.

Table 2

| (i) | (j) | (k) Timing of initial crystallization process after layer forming process | | | | | | |
|---|---|---|---|---|---|---|---|---|
| | | immediately after | 2 days after | 3 days after | 4 days after | 6 days after | 11 days after | After 24 hour Acceleration |
| 45 sec | 0.3 sec | none | none | none | change in color | change in color | change in color | change in color |
| 45 sec | 1.0 sec | none | none | none | none | none | change in color | change in color |
| 45 sec | 2.0 sec | none | none | none | none | none | none | change in color |
| 45 sec | 3.0 sec | none | none | none | none | none | none | change in color |
| 45 sec | 5.0 sec | none | none | None | none | none | none | change in color |
| 120 sec | 0.3 sec | none | none | change in color | change in color | change in color | change in color | change in color |
| 120 sec | 1.0 sec | none | none | none | none | change in color | change in color | change in color |
| 120 sec | 2.0 sec | none | none | none | none | none | change in color | change in color |
| 120 sec | 3.0 sec | none | none | none | none | none | change in color | change in color |
| 120 sec | 5.0 sec | none | none | none | none | none | change in color | change in color |
| 250 sec | 0.3 sec | none | change in color | change in color | change in color | change in color | change in color | change in color |
| 250 sec | 1.0 sec | none | none | none | change in color | change in color | change in color | change in color |
| 250 sec | 2.0 sec | none | none | none | none | change in color | change in color | change in color |
| 250 sec | 3.0 sec | none | none | none | none | change in color | change in color | change in color |
| 250 sec | 5.0 sec | none | none | none | none | none | change in color | change in color |

To decrease the size particle of Ag, it is necessary to form layers under the condition in which aggregation of Ag can be prevented. Specifically, it is possible to prevent such aggregation of Ag by controlling incident frequency of Ag atoms or clusters, and other atoms, molecules, ions or clusters into the surface of a layer in the process of forming an optical reflective layer. More specifically, it is effective to increase the flux of coexistent gases such as Ar, $N_2$ and $O_2$ in the sputtering layer forming process to increase incident frequency of the coexistent gases into the surface of a layer. It is also effective to increase the incident frequency of the coexistent gases into the surface of a layer by forming a layer while reducing the emission speed and increasing the layer forming pressure. In addition, to reduce the incident frequency of Ag into the surface of a layer, it is effective to decrease the speed of layer forming by lowering the sputtering voltage for layer forming. Further, it is also effective to lower the temperature of a substrate during forming an optical reflective layer containing Ag. In actual layer forming, the size of Ag particles can be controlled by adjusting these conditions.

To reduce the size of Ag particles, it is also effective to make other substances coexistent during layer forming. Specific examples of such other substances include Mg, Al, Si, Ca, Ti, Cr, Cu, Zn, Y, Ce, Nd, Gd, Tb, Dy, Nb, Mo, Pd, In, Sn, Ta, W and Pt . When Ag particles grow in size, these additives come to be contained in a large amount in a portion forming its particle boundary. Therefore, due to the existence of these additives, Ag particles can be reduced in size. The selection and the addition amount of these metals are dependent on sputtering conditions for an optical reflective layer containing Ag. When these additives are added in a large amount, it is easy to reduce the size of Ag particles, but properties Ag is expected to impart, for example, high reflectivity and high thermal conductivity, degrade. When these additives are added in a small amount, properties Ag is expected to impart are secured but layer forming conditions should be strictly controlled. As mentioned above, considering selection and amount of these additives and layer forming conditions for an optical reflective layer containing Ag is essential.

When Cu, Pd and/or Pt are selected, which are easy to alloy with Ag, the size of Ag particles can be reduced without spoiling the characteristics of Ag. However, it is necessary to control the layer forming conditions to reduce the size of Ag particles because of the tendency of these metals of alloying with Ag. On the other hand, when metals such as Mg, Al, Si, Ca, Ti, Cr, Zn, Nb, Mo, In, Sn, Ta and W are added in a large amount, the characteristics of Ag are significantly impaired. However, these metals tend to absorb the coexistent gases during layer forming and effectively works for forming particle boundary. Thereby, it is possible to restrain the size increase of Ag crystal particles and effective to reduce the size thereof. In addition, additives such as Y, Ce, Nd, Gd, Tb, Dy, Zr, Hf, In and Sn have a relatively large atomic diameter in comparison with that of Ag. Therefore, it is possible to restrain the crystal growth of Ag particles so that Ag crystal particle diameter can be reduced.

According to the result of the study by the inventors of the present invention, it is found that the level at which the impact of particle boundary noise of an optical reflective layer containing Ag on recording and playback signals can be ignored is not greater than 1/3 of the minimum recording mark. As a result of consideration about this level by the inventors of the present invention, it is found that 1/3 of the minimum recording mark corresponds to a channel bit of a recording mark. The channel bit is the minimum unit corresponding to "0" and "1" for information of optical recording. In the case of a DVD-ROM, it is 0.133 $\mu$m. That is, as for DVD-Rs, DVD-RWs, DVD + Rs and DVD+RWs, the length lag of an average crystal particle in the recording track direction in an optical reflective layer is acceptable when the lag is not greater than one bit length Lbi (0.133 $\mu$m) of a mark. Namely, the crystal particle diameter of an optical reflective layer containing Ag should be not greater than a channel bit length, and preferably not greater than 2/3 thereof when taking into consideration variance of the crystal particle diameters.

When a guide groove existing in an optical recording medium is wobbled, the particle diameter is necessary to be sufficiently small in comparison with the cycle of the wobble. It is impossible to read the wobbling of the guide groove in an optical recording medium with an optical recording device when the optical recording device reads the particle boundary of Ag particles as noise. That is, the addresses in the optical recording medium are not correctly read. This reading problem is further serious for an optical recording medium such as a DVD-R and a DVD-RW having a guide groove with pits.

With regard to the relationships between the crystal particle diameter of an optical reflective layer containing Ag and the wobbling of a guide groove, it is preferred that the crystal particle diameter is not greater than 1/10 of the one wobbling cycle. This is because when a noise is inserted in a 1/10 of one wobbling cycle, the information for the wobbling can be compensated. It is more preferred that the crystal particle diameter is not greater than 1/20 of the one wobbling cycle. This is because when a noise is inserted in a 1/20 of one wobbling cycle, the noise is ignorable. In addition, when a wobbling guide groove have pits, the Ag crystal particle diameter is not greater than 1/10 of the pit interval and preferably not greater than 1/20 thereof.

As a result of the experiment performed by the inventors of the present invention, it is found that the moisture absorbed in the surface of a substrate has an impact on the cohesion strength between an optical reflective layer containing Ag and a layer on which the optical reflective layer containing Ag is formed. Therefore, when the passivation ability of the intermediate layer on which an optical reflective layer containing Ag is formed is improved, the cohesion strength between the optical reflective layer containing Ag and the intermediate layer can be improved.

The inventors of the present invention have inferred that it is effective that an intermediate layer contains the materials containing the following (1) and (2) to secure the cohesion strength with an optical reflective layer containing Ag together with the passivation ability of preventing reaction between ZnS·SiO$_2$ and Ag.

(1) To secure the passivation ability, a material capable of forming an intrusion type compound in which atoms are densely packed (the intrusion type compound represents a compound in which non-metallic atoms having a small particle size intrude in the space in the metal crystal lattice or atom lattice); and

(2) To secure the cohesion strength, a material capable of securing wet property of the optical reflective layer containing Ag and the intermediate layer.

The intermediate layer of the disclosure contains at least one of Ti, Nb and Ta, carbon and oxygen. However, considering (1) and (2) mentioned above, it is preferred that the intermediate layer contains Ti, Nb, Ta, carbon and oxygen in a form of their carbides and oxides.

The inventors of the present invention studied an intermediate layer formed of a carbide target of Si, Ti, Zr, Nb and Ta which could form an intrusion type compound to secure the passivation ability and a target formed of a metal oxide of the metals to secure wet property of an optical reflective layer containing Ag and the intermediate layer.

The optical recording medium studied had a layer structure of an information substrate having a guide groove, a bottom protective layer, an interface layer, an optical recording layer, a top protective layer, an intermediate layer, an optical reflective layer, an ultraviolet setting resin, an adhesive layer and a cover substrate.

A polycarbonate substrate having a thickness of 0.6 mm and a guide groove having a width of 0.25 $\mu$m, a depth of 27 nm and a wobbling cycle of 4.26 $\mu$m is prepared by projection-molding as the information substrate having a guide groove. The bottom protective layer, the interface layer, the optical recording layer, the top protective layer, the intermediate layer, the optical reflective layer were accumulated on the information substrate by sputtering in this order. The bottom protective layer had a thickness of 55 nm and was formed of $(ZnS)_{80} (SiO_2)_{20}$ by mol %. The interface layer had a thickness of 4 nm and was formed of $SiO_2$. The optical recording layer had a thickness of 11 nm and was formed of $Ge_8Ga_6Sb_{68}Sn_{18}$ by mol %. The top protective layer had a thickness of 11 nm and was formed of $(ZnS)_{80}(SiO_2)_{20}$ by mol %. The optical reflective layer had a thickness of 140 nm and was formed of solid silver. The intermediate layer had a thickness of 6 nm and was formed of the material described later. The bottom protective layer, the interface layer and the top protective layer were prepared by RF sputtering method. The optical recording layer and the optical reflective layer were prepared by DC sputtering method.

The intermediate layer was prepared by DC or RF sputtering of sintered target formed of a carbide and an oxide. The carbides used were Sic, TiC, ZrC, NbC and TaC. The oxides used were $SiO_2$, $TiO_2$, $ZrO_2$, $Nb_2O_5$ and $Ta_2O_5$.

Next, an ultraviolet setting resin (SD318, manufactured by Dainippon ink and Chemical Incorporated) having a viscosity of 120 cps at room temperature and a glass transition temperature of 149 °C after being set was spin-coated on the optical reflective layer to form the resin protective layer. A single plate disc of a phase change type optical recording medium was thus prepared.

Next, a polycarbonate substrate for attachment was bonded to the single plate disc with an ultraviolet setting adhesive (DVD003, manufactured by Nippon Kayaku Co., Ltd.) having a viscosity of 450 cps at room temperature and a glass transition temperature of 75 °C after being set. A phase change type optical recording medium was thus obtained.

Next, the optical recording layer was totally crystallized from inner to outer of the disc by an initialization device manufactured by Hitachi Computer Peripherals Co., Ltd. having a large aperture LD (beam diameter: 75 $\mu$m x 1 $\mu$m) with a constant linear velocity of 70 % of the maximum recording linear velocity of the disc, an electric power of 1,600 mW and a sending pitch of 45 $\mu$m/r.

Manufacturing variance resistance of the optical recording medium was evaluated with regard to the following (1) to (3).

(1) DC sputtering possibility;
(2) Resistance for air leak during forming the intermediate layer; and
(3) Initialization resistance.

The resistance evaluation process conditions were the following (1) to (3) .

(1) Possibility of use of DC sputtering for layer forming;
(2) Errors of optically recorded signals on a disc having an intermediate layer formed with an air leak of 1 x 10$^{-4}$ mbar after 24 hour preservation of the disc at 80 °C and 85 %RH (No good when PI error increased not less than 50 %) ; and
(3) Defect ratio of the discs initialized after 24 hour accelerated deterioration at 80 °C and 85 %RH (No good when the ratio was not less than 1 x 10$^{-4}$).

The recording characteristics of the optical recording media were determined by "Groove reflectivity (%)" and "Sensitivity (recording power (mW))" at a recording power by which jitter after recording was minimized.

The optical recording was performed using the irradiation pulse patterns illustrated in JOP H9-138947, 2001-250230 and 2002-288828 including the multiple pulses formed by the combination mentioned above of Pw and Pb illustrated in Fig. 1. The recording format adopted was compatible with that for DVD playback.

The manufacturing process margin and recording characteristics of an 8× DVD+RW disc having an intermediate layer formed by sputtering using a sintered target containing one combination of a carbide and an oxide selected from the combinations of SiC-$SiO_2$, ZrC-$ZrO_2$, TiC and $TiO_2$, NbC-$Nb_2O_5$ and TaC-$Ta_2O_5$ while changing their composition ratio are shown in Tables 3 to 7, in which "NG" means "no good" and "G" means "good".

As seen in Table 3, in the case of the intermediate layer formed of a compound containing SiC-$SiO_2$, there was no air leak resistance during forming the intermediate layer, no abandoned time margin before initialization. In addition the production process margin was narrow.

As seen in Table 4, in the case of the intermediate layer formed of a compound containing ZrC-$ZrO_2$, there was air leak resistance during forming the intermediate layer but there was no abandoned time margin before initialization.

In addition, the production process margin was narrow.

In contrast, as seen in Tables 5 to 7, for the intermediate layers formed of a compound containing $TiC-TiO_2$, $NbC-Nb_2O_5$ and $TaC-Ta_2O_5$, there was air leak resistance during forming the intermediate layers and sufficient abandoned time margin before initialization. In addition, the production process margin was wide. However, for the intermediate layer singly formed of a carbide, the reflectivity thereof was relatively small in comparison with that of the intermediate layer formed of the carbide plus an oxide. An oxide is thus added to secure the margin of the recording characteristics.

Judging from the results described above, the intermediate layer formed of SiC has a poor air leak resistance and a narrow process margin for initialization because SiC is relatively unstable in comparison with the other carbides. This is thought to be because the enthalpy of formation of SiC is significantly small in comparison with that of the other carbides. In addition, in the case of the intermediate layer containing $ZrC-ZrO_2$, the result is ascribable to inferior passivation ability of ZrC in comparison with that of the other carbides. This is thought to be because, in forming intrusion type metal compounds, the other metals have a relatively small covalent bond radius, i.e., 13.2 nm for Ti, 13.4 nm for Nb and 13.4 nm for Ta, in comparison with 14.5 nm for Zr so that these other metals can suitably pack with C and passivation ability thereof is high.

In addition, for the intermediate layer containing $TiC-TiO_2$, DC sputtering is possible and production stability is excellent when the following relationships are satisfied: $37 \leq \alpha_1 \leq 48$, $12 \leq \beta_1 \leq 45$, $7 \leq \gamma_1 \leq 51$ and $\alpha_1 + \beta_1 + \gamma_1 = 100$, wherein $\alpha_1$, $\beta_1$ and $\gamma_1$ (atomic %) represent the composition ratio of Ti, C and O contained in the target, respectively. For the intermediate layer containing $NbC-Nb_2O_5$, DC sputtering is possible and production stability is excellent when the following relationships are satisfied: $33 \leq \alpha_2 \leq 47$, $9 \leq \beta_2 \leq 43$, $10 \leq \gamma_2 \leq 58$ and $\alpha_2 + \beta_2 + \gamma_2 = 100$, wherein $\alpha_2$, $\beta_2$ and $\gamma_2$ (atomic %) represent the composition ratio of Nb, C and O contained in the target, respectively. For the intermediate layer containing $TaC-Ta_2O_5$, DC sputtering is possible and production stability is excellent when the following relationships are satisfied: $32 \leq \alpha_3 \leq 47$, $9 \leq \beta_3 \leq 43$, $10 \leq \gamma_3 \leq 59$ and $\alpha_3 + \beta_3 + \gamma_3 = 100$, wherein $\alpha_3$, $\beta_3$ and $\gamma_3$ (atomic %) represent the composition ratio of Ta, C and O contained in the target, respectively. The composition ratio of the intermediate layer is usually almost the same as that of the target.

The results described above are those for an intermediate layer containing a single kind of metal. Similar effects were confirmed when multiple kinds of metals such as Ti-Nb-O-C, Ti-Ta-O-C and Nb-Ta-O-C were used. However, the intermediate layer containing a single kind of metal is effective in terms of oxidation and reduction.

It is preferred that the intermediate layer is formed of a material containing only carbide and oxide of the metals mentioned above. However, a content of impurities is allowed in an amount not greater than 1% by weight as long as the impurities do not inadvertently affect the characteristics of the intermediate layer.

According to the present invention, optical recording media for a high recording linear velocity, for example, a $4\times$ DVD+RW (not lower than 14 m/s) and an $8\times$ or higher DVD+RW (not lower than 28 m/s), can be obtained by providing the intermediate layer mentioned above.

It is effective to have an intermediate layer having a thickness of from 1 to 9 nm, preferably from 2 to 8 nm and more preferably from 3 to 7 nm. When the thickness was too thin, the intermediate layer did not function as a barrier layer. This is thought to be because the layer has an island shape structure. When the thickness was too thick, the recording properties of the intermediate layer, especially the reflectivity, extremely deteriorated.

The intermediate layer of the present invention was analyzed by various kinds of methods. When an intermediate layer containing $TiC-TiO_2$ was analyzed by Auger Electron Spectroscopy (AES), the existence of Ti, C and O was confirmed. When the intermediate layer containing $TiC-TiO_2$ was analyzed by X-ray Photoelectron Spectroscopy (XPS), the existence of the chemical linkages of Ti-O and Ti-C was confirmed. When the intermediate layer containing $TiC-TiO_2$ was analyzed by electron diffraction based on a cross section transmission electron microscope (TEM) analysis, crystalline property was not clearly confirmed. In addition, a mixture phase structure such as an oxide and a carbide was not also found. Although the chemical structure of the intermediate layer was close to the target structure, since C and O were coexistent, C and O emit from the intermediate layer as CO or $CO_2$ in some amount, resulting in a metal rich structure. An intermediate layer containing $NbC-Nb_2O_5$ or $TaC-Ta_2O_5$ had the same result as that containing $TiC-TiO_2$.

Table 3

| | Composition ratio (feed) | | | | Process margin | | | Recording characteristics | |
|---|---|---|---|---|---|---|---|---|---|
| | Si | O | C | Si + O + C | Sputter method | Leak resistance | Initialization resistance | Reflectivity | Sensitivity |
| Sample No. | Atom % | Atom % | Atom % | Atom % | DC or RF | Air leak of $5 \times 10^{-4}$ mbar | Accelerated Deterioration 24 hour, 80 °C, 85 %RH | > 18 % | < 35 mW |
| Si-1 | 50 | 0 | 50 | 100 | DC | NG | NG | G | G |
| Si-2 | 48 | 7 | 45 | 100 | DC | NG | NG | G | G |
| Si-3 | 47 | 13 | 40 | 100 | DC | NG | NG | G | G |
| Si-4 | 45 | 20 | 35 | 100 | RF | NG | NG | G | G |
| Si-5 | 43 | 27 | 30 | 100 | RF | NG | NG | G | G |
| Si-6 | 42 | 33 | 25 | 100 | RF | NG | NG | G | G |
| Si-7 | 40 | 40 | 20 | 100 | RF | NG | NG | G | G |
| Si-8 | 38 | 47 | 15 | 100 | RF | NG | NG | G | G |
| Si-9 | 37 | 53 | 10 | 100 | RF | NG | NG | G | G |
| Si-10 | 35 | 60 | 5 | 100 | RF | NG | NG | G | G |

Process characteristics and disc characteristics of intermediate layer containing $SiC-SiO_2$

Table 4

| | Composition ratio (feed) | | | | Process margin | | | Recording characteristics | |
|---|---|---|---|---|---|---|---|---|---|
| | Zr | O | C | Zr + O + C | Sputter method | Leak resistance | Initialization resistance | Reflectivity | Sensitivity |
| Sample No. | Atom % | Atom % | Atom % | Atom % | DC or RF | Air leak of $5 \times 10^{-4}$ mbar | Accelerated Deterioration 24 hour, 80 °C, 85 %RH | > 18 % | < 35 mW |
| Zr-1 | 50 | 0 | 50 | 100 | DC | G | NG | G | G |
| Zr-2 | 48 | 7 | 45 | 100 | DC | G | NG | G | G |
| Zr-3 | 47 | 13 | 40 | 100 | DC | G | NG | G | G |
| Zr-4 | 45 | 20 | 35 | 100 | DC | G | NG | G | G |
| Zr-5 | 43 | 27 | 30 | 100 | DC | G | NG | G | G |
| Zr-6 | 42 | 33 | 25 | 100 | DC | G | NG | G | G |
| Zr-7 | 40 | 40 | 20 | 100 | RF | G | NG | G | G |
| Zr-8 | 38 | 47 | 15 | 100 | RF | G | NG | G | G |
| Zr-9 | 37 | 53 | 10 | 100 | RF | G | NG | G | G |
| Zr-10 | 35 | 60 | 5 | 100 | RF | G | NG | G | G |

Process characteristics and disc characteristics of intermediate layer containing $ZrC-ZrO_2$

Table 5

| | Composition ratio (feed) | | | | Process margin | | | Recording characteristics | |
|---|---|---|---|---|---|---|---|---|---|
| | Process characteristics and disc characteristics of intermediate layer containing TiC-TiO$_2$ | | | | | | | | |
| Sample No. | Ti | O | C | Ti + O + C | Sputter method | Leak resistance | Initialization resistance | Reflectivity | Sensitivity |
| | Atom % | Atom % | Atom % | Atom % | DC or RF | Air leak of 5 x 10$^{-4}$ mbar | Accelerated Deterioration 24 hour, 80 °C, 85 %RH | > 18 % | < 35 mW |
| Ti-1 | 50 | 0 | 50 | 100 | DC | G | G | G | G |
| Ti-2 | 48 | 7 | 45 | 100 | DC | G | G | G | G |
| Ti-3 | 47 | 13 | 40 | 100 | DC | G | G | G | G |
| Ti-4 | 45 | 20 | 35 | 100 | DC | G | G | G | G |
| Ti-5 | 43 | 27 | 30 | 100 | DC | G | G | G | G |
| Ti-6 | 42 | 33 | 25 | 100 | DC | G | G | G | G |
| Ti-7 | 40 | 40 | 20 | 100 | RF | G | G | G | G |
| Ti-8 | 38 | 47 | 15 | 100 | RF | G | G | G | G |
| Ti-9 | 37 | 53 | 10 | 100 | RF | G | G | G | G |
| Ti-10 | 35 | 60 | 5 | 100 | RF | G | G | G | G |

Table 6

| | Composition ratio (feed) | | | | Process margin | | | Recording characteristics | |
|---|---|---|---|---|---|---|---|---|---|
| | Process characteristics and disc characteristics of intermediate layer containing NbC-Nb$_2$O$_5$ | | | | | | | | |
| Sample No. | Nb | O | C | Nb + O + C | Sputter method | Leak resistance | Initialization resistance | Reflectivity | Sensitivity |
| | Atom % | Atom % | Atom % | Atom % | DC or RF | Air leak of 5 x 10$^{-4}$ mbar | Accelerated Deterioration 24 hour, 80 °C, 85 %RH | > 18 % | < 35 mW |
| Nb-1 | 50 | 0 | 50 | 100 | DC | G | G | G | G |
| Nb-2 | 48 | 7 | 45 | 100 | DC | G | G | G | G |
| Nb-3 | 46 | 14 | 40 | 100 | DC | G | G | G | G |
| Nb-4 | 44 | 21 | 35 | 100 | DC | G | G | G | G |
| Nb-5 | 41 | 29 | 30 | 100 | DC | G | G | G | G |
| Nb-6 | 39 | 36 | 25 | 100 | RF | G | G | G | G |
| Nb-7 | 37 | 43 | 20 | 100 | RF | G | G | G | G |
| Nb-8 | 35 | 50 | 15 | 100 | RF | G | G | G | G |
| Nb-9 | 33 | 57 | 10 | 100 | RF | G | G | G | G |
| Nb-10 | 31 | 64 | 5 | 100 | RF | G | G | G | G |

Table 7

| Process characteristics and disc characteristics of intermediate layer containing TaC-Ta$_2$O$_5$ | | | | | | | | |
|---|---|---|---|---|---|---|---|---|
| Sample No. | Composition ratio (feed) | | | | Process margin | | | Recording characteristics | |
| | Ta | O | C | Ta + O + C | Sputter method | Leak resistance | Initialization resistance | Reflectivity | Sensitivity |
| | Atom % | Atom % | Atom % | Atom % | DC or RF | Air leak of 5 x 10$^{-4}$ mbar | Accelerated Deterioration 24 hour, 80 °C, 85 %RH | > 18 % | < 35 mW |
| Ta-1 | 50 | 0 | 50 | 100 | DC | G | G | G | G |
| Ta-2 | 48 | 7 | 45 | 100 | DC | G | G | G | G |
| Ta-3 | 46 | 14 | 40 | 100 | DC | G | G | G | G |
| Ta-4 | 44 | 21 | 35 | 100 | DC | G | G | G | G |
| Ta-5 | 41 | 29 | 30 | 100 | DC | G | G | G | G |
| Ta-6 | 39 | 36 | 25 | 100 | RF | G | G | G | G |
| Ta-7 | 37 | 43 | 20 | 100 | RF | G | G | G | G |
| Ta-8 | 35 | 50 | 15 | 100 | RF | G | G | G | G |
| Ta-9 | 33 | 57 | 10 | 100 | RF | G | G | G | G |
| Ta-10 | 31 | 64 | 5 | 100 | RF | G | G | G | G |

Fig. 2 is a diagram illustrating an example of the layer structure of the present invention.

Fig. 2 is a diagram illustrating an example (of the optical recording medium, the phase change type optical recording medium (DVD) in this case), of the present invention, in which a bottom protective layer (2), an optical recording layer (4), a top protective layer (6), an optical reflective layer containing Ag (8), a resin layer and/or an adhesive layer (9), and a cover substrate (10) are formed on an information substrate having a wobbled guide groove (1) in this order. To improve the performance of the medium, a first interface layer (3), a second interface layer (5), an intermediate layer (7) and a printing layer (11) are formed on a necessity basis. In addition, an optical recording medium having the same or similar structure can be accumulated on the opposite side of the cover substrate (10) in the reversed order to form an optical recording medium having two recording layers.

The present invention is not limited to the structures mentioned above but is applicable to various kinds of optical recording media having an optical reflective layer containing Ag.

The material for use in the substrate is typically glass, ceramics or resins. Among these, a resin substrate is preferred in terms of moldability and cost. Specific examples of resins include polycarbonate resins, acryl resins, epoxy resins, polystyrene resins, acrylonitrile-styrene copolymer resins, polyethylene resins, polypropylene resins, silicone resins, fluoride containing resins, acrylonitrile butadiene styrene (ABS) resins and urethane resins. Among these, polycarbonate resins and acryl-based resins are preferred in light of moldability, optical characteristics and cost.

However, when the optical recording medium of the present invention is applied to a DVD+R, it is preferred to add the following particular conditions: the guide groove formed on a substrate has a width of from 0.10 to 0.40 $\mu$m and preferably from 0.15 to 0.35 $\mu$m, a depth of from 120 to 200 nm and preferably from 140 to 180 nm and a wobbling cycle of 4.3 $\mu$m; the thickness of the substrate is preferably from 0.55 to 0.65 mm; and the thickness of the disc after bonding is preferably from 1.1 to 1.3 mm. Playback compatibility with a DVD-ROM drive can be improved by having such a guide groove.

In addition, when the optical recording medium of the present invention is applied to a DVD+RW, it is preferred to add the following particular conditions: the guide groove formed on a substrate has a width of from 0.10 to 0.40 $\mu$m and preferably from 0.15 to 0.35 $\mu$m, a depth of from 15 to 45 nm and preferably from 20 to 40 nm and a wobbling cycle of 4.3 $\mu$m; the thickness of the substrate is preferably from 0.55 to 0.65 mm; and the thickness of the disc after bonding is preferably from 1.1 to 1.3 mm. Playback compatibility with a DVD-ROM drive can be improved by having such a guide groove.

Specific examples of materials for use in the bottom and top protective layer of the phase change type optical recording media include oxides such as SiO, SiO$_2$, ZnO, SnO$_2$, Al$_2$O$_3$, TiO$_2$, In$_2$O$_3$, MgO and ZrO$_2$; nitrides such as Si$_3$N$_4$, AlN, TiN, BN and ZrN; sulfides such as ZnS and TaS$_4$; carbides such as SiC, TaC, B$_4$C, WC, TiC and ZrC; carbon having a diamond structure; and combinations thereof. Among these, materials containing ZnS and SiO$_2$ such as $(ZnS)_{85}$ $(SiO_2)_{15}$, $(ZnS)_{80}(SiO_2)_{20}$, $(ZnS)_{75}(SiO_2)_{25}$ by mol % are preferred. Especially, for the bottom protective layer located between the substrate and the phase change type optical recording layer vulnerable to thermal damage by high temperature and changes in ambient temperature, $(ZnS)_{80}(SiO_2)_{20}$ by mol % is preferred in which the optical constants, thermal expansion coefficient and elasticity thereof are optimized.

The thickness of the bottom protective layer has a great impact on reflectivity, modulation level, and recording sensitivity. Therefore, it is preferred that the thickness thereof is such that the disc reflectivity shows minimum values. In this layer thickness range, the recording sensitivity is excellent and information can be recorded with a small power with which thermal damage can be restrained so that overwriting performance can be improved. To obtain good signal characteristics in the range of DVD recording and playback wavelengths, when the bottom protective layer is formed of $(ZnS)_{80}(SiO_2)_{20}$ by mol %, it is preferred that the bottom protective layer has a thickness of from 45 to 65 nm. When the layer thickness is too thin, the thermal damage to the substrate is significant and the guide form is transformed. In contrast, when the layer thickness is too thick, the disc reflectivity is high and the sensitivity deteriorates.

Further, for the top protective layer free from sulfur in a phase change type optical recording medium, it is preferred to use materials which can restrain the occurrence of cracking and have a suitable sputtering speed for manufacturing optical recording media. Specific examples of such preferred materials include zinc oxides, indium oxides, tin oxides, niobium oxides, silicon nitrides and aluminum nitrides. In the present invention, these preferred materials are used as main component. The main component means that the main component occupies greater than 50 % by mol. The materials for use in the present invention are preferred to contain oxides of Si, Al, Ti, Zn, Zr, Mo, Ta, Nb and W as additives. Oxygen contained in these oxides can have network due to its considerable free latitude for divalent link revolution, which is preferred in terms of flexibility of the layer. However, when the top protective layer is too thick, cracking tends to occur because of internal stress of the layer itself and thermal stress between the optical recording layer and the optical reflective layer containing Ag or Ag alloy. In addition, the top protective layer can be formed of multiple layers. Thereby interface layers of the top protective layer are formed to prevent thermal conduction, resulting in formation of a thermal accumulation structure. Thus the sensitivity of optical recording can be improved. The top protective layer is preferably has a thickness of from 4 to 24 nm. When the thickness thereof is too thin, the top protective layer does not sufficiently function as a thermal accumulation layer. Meaning, it is difficult to perform recording with a semiconductor laser beam currently used. When the layer thickness is too thick, cracking tends to occur as mentioned above. It is more preferred that the top protective layer has a thickness of from 8 to 20 nm.

In addition, the phase change type optical recording media are manufactured by continuously forming the layers of a bottom protective layer, an optical recording layer, a top protective layer and an optical reflective layer by sputtering. When forming these layers, since the top protective layer or the optical reflective layer is relatively thick in comparison with that of the other layers, the top protective layer or the optical reflective layer takes the longest time to form. Therefore, to efficiently form the top protective layer, layer forming conditions therefor are preferred under which the top protective layer can be formed in a time not longer than the bottom protective layer or the optical reflective layer can be. When the bottom protective layer is formed of ZnS·SiO$_2$, the reflective layer is formed of Ag or Ag alloy and the target sputtering time is set to be 7 seconds, the speed of forming the top protective layer is required to be not slower than 1 nm/s and preferably not slower than 3 nm/s.

On the other hand, when a top protective layer having a thickness of from 4 to 24 nm is formed with too high a layer forming speed, the ratio of the rise time of generation of plasma during sputtering layer forming becomes large. Therefore, the layer thickness significantly varies depending on discs and thus the variance of the sensitivity is wide. To reduce the variance in thickness among the top protective layers formed, the speed of layer forming is required to be not greater than 10 nm/s and preferably not greater than 8 nm/s.

Further, to secure the initialization conditions, especially the power margin, in the manufacturing process of phase change type optical recording media, it was effective to form Ag-O linkage in the interface between the top protective layer and the optical reflective layer containing Ag or Ag alloy. Formation of Ag-O linkage was confirmed by analyzing methods such as X-ray Photoelectron Spectroscopy (XPS). When AlN and Si$_3$N$_4$ were used in the top protective layer, since oxygen was supplied from emission gas from and remaining gas in the substrate, formation of Ag-O linkage was confirmed. However, as compared with the top protective layer containing an oxide, the amount of Ag-O linkage was relatively small and the power margin at initialization tended to be narrow.

Phase change materials containing Sb in an amount of from 60 to 90 atomic % are preferred as phase change type optical recording materials. Specific examples of such phase change materials include InSb, GaSb, GeSb, GeSbSn, GaGeSb, GeSbTe, GaGeSbSn, AgInSbTe, GeInSbTe and GeGaSbTe, all of which contain Sb in an amount of 60 to 90 atomic %. More specific examples are materials which can deal with a 4× DVD such as Ag$_\alpha$Ge$_\beta$In$_\gamma$Sb$_\delta$Te$_\varepsilon$, satisfying the following relationships: $0 \leq \alpha \leq 5$; $0 \leq \beta \leq 5$; $2 \leq \gamma \leq 10$; $60 \leq \delta \leq 90$; $15 \leq \varepsilon \leq 30$; and $\alpha + \beta + \gamma + \delta + \varepsilon = 100$, wherein $\alpha$, $\beta$, $\gamma$, $\delta$ and $\varepsilon$ represent atomic %, and materials which can deal with an 8× DVD such as Ga$_{\alpha'1}$In$_{\alpha'2}$Ge$_\beta$Sb$_\gamma$Sn$_\delta$Bi$_{\varepsilon'1}$Te$_{\varepsilon'2}$, satisfying the following relationships: $0 \leq \alpha'1 \leq 20$; $0 \leq \alpha'2 \leq 20$; $2 \leq \alpha'1 + \alpha'2 \leq 20$; $2 \leq \beta' \leq 20$; $60 \leq \gamma \leq 90$; $5 \leq \delta' \leq 25$; $0 \leq \varepsilon'1 \leq 10$; $0 \leq \varepsilon'2 \leq 10$; $0 \leq \varepsilon'1 + \varepsilon'2 \leq 10$; and $\alpha'1 + \alpha'2 + \beta' + \gamma + \delta' + \varepsilon'1 + \varepsilon'2 = 100$, wherein $\alpha'1$, $\alpha'2$, $\beta'$, $\gamma$, $\delta'$, $\varepsilon'1$ and

ε'2 represent atomic %.

When a DVD+RW medium is manufactured by using these phase change materials, it is already known that the recording time can be shortened when the amount of Sb contained in the recording layer is not smaller than 60 atomic % according to the relationship between the Sb composition ratio and the time to be taken to record the minimum recording mark having DVD compatibility or CD compatibility. That is, it is possible to shorten the melting time of an optical recording layer during erasing a record and to reduce thermal damage to the optical recording layer and its top protective layer. In addition, when the amount of Sb is not smaller than 60 atomic %, initial melting crystallization of an optical recording medium can be performed at a high speed, resulting in reduction of thermal damage thereto. Furthermore, when the amount of Sb is not smaller than 70 atomic %, it is possible to have a linear velocity for initialization not slower than 10 m/s, thereby reducing thermal damage. However, it is not preferred to increase the amount Sb to a value greater than 90 atomic %. This is because the reliability of recording marks in a high temperature and high humidity environment is inferior even when various kinds of additives are added.

The thickness of the phase change type optical recording layer is preferably from 8 to 14 nm. When the thickness thereof is too thin, crystallization of the recording marks in a high temperature and high humidity environment at 80 °C and 85 %RH is sped up, which leads to a life length problem. When the layer thickness is too thick, the heat generated at the time of erasing optical recording increases and thermal damage to the top protective layer is significant, resulting in induction of cracking thereof.

Methods such as plasma chemical vapor deposition (CVD) methods, plasma treatment methods, ion plating methods and optical chemical vapor deposition (CVD) can be used to form a bottom protective layer, an optical recording layer, a top protective layer and an optical reflective layer containing Ag or Ag alloy. However, sputtering, which is the method typically for use in manufacturing optical recording media, is effective. The typical manufacturing conditions for sputtering methods are: pressure of from $10^{-2}$ to $10^{-4}$ mbar, sputtering power of from 0.1 to 5. 0 kW/200 mm Φ and layer forming speed of from 0.1 to 50 nm/s.

As for a dye recording layer, conventional dyes such as cyanine dyes, azo dyes, phthalocyanine dyes and squarylium dyes can be used. In the case of metal complexes, it is effective to include elements selected from the group consisting of Ti, Zr, Hf, V, Nb, Ta, Cr, Mo and W as mentioned in the present invention as matching for an optical recording medium containing Ag.

As for a resin protective layer, it is preferred to use an ultraviolet setting resin manufactured by a spin coating method. The thickness thereof is preferably from 3 to 15 μm. When the layer thickness is too thin, the number of errors may increase when a printing layer is provided on an overcoat layer. In contrast, when the layer thickness is too thick, its internal stress increases, which has a great impact on the mechanical property of the disc.

When a hard coating layer is provided, typically an ultraviolet setting resin manufactured by a spin coating method is used. The thickness thereof is preferably from 2 to 6 μm. When the layer thickness is too thin, sufficient anti-scratch property is not obtained. In contrast, when the layer thickness is too thick, its internal stress increases, which has a great impact on the mechanical property of the disc. The hardness of the hard coating layer required is not less than an H pencil hardness, which is such that a disc is not greatly scratched when the disc is rubbed with a cloth. Further, it is effective to admix electroconductive materials to prevent the hard coating layer from being charged so that the hard coating layer does not attract dirt, etc., if necessary.

A printing layer is provided to secure anti-scratch property, print a label such as a brand name thereon and form an ink absorbing layer for a ink jet printer. It is preferred to form a printing layer using an ultraviolet setting resin by a screen printing method. The thickness of a printing layer is preferably from 3 to 50 μm. When the layer thickness is too thin, a uniform layer is not obtained. When the layer thickness is too thick, its internal stress becomes large, which has a great impact on the mechanical strength of the disc.

An adhesive layer can be formed using adhesives such as ultraviolet resins, hot melt adhesives and silicone resins. These materials are coated on an overcoat layer or a printing layer by methods such as spin coating methods, roll coating methods and screen printing methods, which are selective depending on materials. The formed disc is attached to another disc, which can be a disc of the same kind as the formed disc or just a transparent substrate, through treatment such as ultraviolet irradiation, heating and pressing. The material for the adhesive layer is not necessarily coated on both discs. An adhesive sheet can be also used as an adhesive layer.

There is no specific limit to the thickness of an adhesive layer. Considering the applicability and setting property of a material and the mechanical strength of a disc, its thickness is from 5 to 100 μm and preferably from 7 to 80 μm. There is no particular limit to the adhesive area. However, when an adhesive layer is applied to a rewritable disc having DVD and/or CD compatibility, the end of inner portion in the adhesive area is from Φ 15 to 40 mm and preferably from Φ 15 to 30 mm to secure the adhesive strength for high speed recording.

Having generally described preferred embodiments of this invention, further understanding can be obtained by reference to certain specific examples which are provided herein for the purpose of illustration only and are not intended to be limiting. In the descriptions in the following examples, the numbers represent weight ratios in parts, unless otherwise specified.

## EXAMPLES

### Example 1

Examples 1 to 3 and Comparative Examples 1 and 2

A polycarbonate substrate was prepared by projection molding. The polycarbonate substrate had a thickness of 0.6 mm and a guide groove having a groove width of 0.25 $\mu$m, a groove depth of 27 nm and a wobbling cycle of 4.26 $\mu$m. A bottom protective layer, an interface layer, an optical recording layer, a top protective layer, an intermediate layer and an optical reflective layer were accumulated on the polycarbonate substrate by a sputtering method in this order. Taking into account moisture absorbed in the polycarbonate substrate, the time to be taken between the projection molding and setting the polycarbonate substrate in the sputtering device was controlled to be within 3 minutes.

The bottom protective layer was formed of $(ZnS)_{80}(SiO_2)_{20}$ (mol %) having a thickness of 55 nm. The interface layer was formed of $ZrO_2$ (containing 3 mol % $Y_2O_3$)-$TiO_2$ (80 : 20 mol %) having a thickness of 3 nm. The optical recording layer was formed of $Ag_1Ge_3In_3Sb_{72}Te_{21}$ having a thickness of 12 nm. The top protective layer was formed of $(ZnS)_{80}(SiO_2)_{20}$ (mol %) having a thickness of 11 nm. As for the intermediate layer, TiC, NbC, TaC, ZrC and SiC having a thickness of 4 nm or 9 nm were used in Example 1, Example 2, Example 3, Comparative Example 1 and Comparative Example 2, respectively. The optical reflective layer was formed of Ag having a thickness of 140 nm.

That is, the layer structure obtained was: the polycarbonate substrate; $ZnS_{(80)}SiO_{2(20)}$ (mol %) having a thickness of 55 nm; $ZrO_2$ (containing 3 mol % $Y_2O_3$)-$TiO_2$ (80 : 20 mol %) having a thickness of 3 nm; $Ag_1Ge_3In_3Sb_{72}Te_{21}$ having a thickness of 12 nm; $ZnS_{(80)}SiO_{2(20)}$ (mol %) having a thickness of 11 nm; TiC (Example 1), NbC (Example 2), TaC (Example 3), ZrC (Comparative Example 1) and SiC (Comparative Example 2) having a thickness 4 or 9 nm; and Ag having a thickness of 140nm.

Among the compounds used in the intermediate layers, TiC, NiC, TaC and ZrC are intrusion type compounds and SiC is a covalent type compound. In addition, the ratio (C to metal) of the atom radius of C to that of the metal in ZrC is not greater than 0.50.

The layer forming conditions of the intermediate layer were that the pressure was 5.5 x $10^{-3}$ mbar and the sputtering speed was 2 nm/s to have a relatively low layer forming speed and increase the incident frequency of absorption gas of the substrate into the surface of the layer.

Next, an ultraviolet setting resin (SD318, manufactured by Dainippon Ink and Chemicals Incorporated) having a viscosity of 120 cps at room temperature and a glass transition temperature of 149 °C after setting was spin-coated on the optical reflective layer to form a resin protective layer. A single plate disc of a phase change type optical recording medium was thus obtained.

Further, a polycarbonate attachment substrate was bonded to the single plate disc with an ultraviolet setting adhesive (DVD003 manufactured by Nippon Kayaku Co., Ltd.) having a viscosity of 450 cps at room temperature and a glass transition temperature of 75 °C after setting to obtain a phase change type optical recording medium.

Next, the optical recording layer was totally crystallized from inner to outer of the disc by an initialization device manufactured by Hitachi Computer Peripherals Co., Ltd. having a large aperture LD (beam diameter: 75 $\mu$m x 1 $\mu$m) with a constant linear velocity, i.e., 10 m/s, a power of 1,200 mW and a sending pitch of 37 $\mu$m/r.

The time taken between the layer forming process and the initial crystallization process and the occurrence of defects such as allochroism, float and detachment immediately after the initial crystallization process were checked. The results are shown in Table 8. "After 24 hour" and "After 96 hour" represent after an acceleration test in which an optical recording medium had been preserved for 24 hours or 96 hours in a high temperature and high humidity environment of 80 °C and 85 %RH.

As seen in Table 8, defects such as allochroism, float and detachment of the sputtered layer were not observed for the discs of Examples 1 to 3. In contrast, for the disc of Comparative Example 1 in which ZrC was used, float of the sputtered layer was observed in the initial crystallization process after the 24 hour acceleration test. Also for the disc of Comparative Example 2 in which SiC was used, black spots, i.e., allochroism of the sputtered layer, were observed in the recording layer in the initial crystallization process of the sputtered layer after the disc was preserved in a normal environment for 11 days. Further, when the sputtered layer was tested for detachment and decomposition, the cohesiveness in the black spot portion significantly deteriorated between the reflective layer and the sputtered layer.

Table 8

| | Target material for intermediate layer | Layer thickness (nm) | Timing of initial crystallization process after layer forming process | | | | | | |
|---|---|---|---|---|---|---|---|---|---|
| | | | immediately after | 5 days after | 8 days after | 11 days after | 14 days after | After 24 hours | After 96 hours |
| Example 1* | TiC | 4 | none | none | none | none | none | none | none |
| | | 9 | none | none | none | none | none | none | none |
| Example 2* | NbC | 4 | none | none | none | none | none | none | none |
| | | 9 | none | none | none | none | none | none | none |
| Example 3* | TaC | 4 | none | none | none | none | none | none | none |
| | | 9 | none | none | none | none | none | none | none |
| Comparative Example 1 | ZrC | 4 | none | none | none | none | none | float | float |
| | | 9 | none | none | none | none | none | float | float |
| Comparative Example 2 | SiC | 4 | none | none | none | change in color | change in color | change in color | change in color |
| | | 9 | none | none | none | change in color | change in color | change in color | change in color |
| * not according to the invention | | | | | | | | | |

EP 1 598 818 B1

Examples 4 to 6 and Comparative Examples 3 and 4

The phase change type optical discs were prepared and initially crystallized in the same manner as in Example 1 except that the target materials for the intermediate layers were changed to TiC-TiO$_2$ (70 : 30 by mol) for Example 4, to NbC-Nb$_2$O$_5$ (70 : 30 by mol) for Example 5, to Tac-Ta$_2$O$_5$ (70 : 30 by mol) for Example 6, to ZrC-ZrO$_2$ (70 : 30 by mol) for Comparative Example 3 and to SiC-SiO$_2$ (70 : 30 by mol) for Comparative Example 4 and the thicknesses of the intermediate layers were changed to 2, 4 and 8 nm.

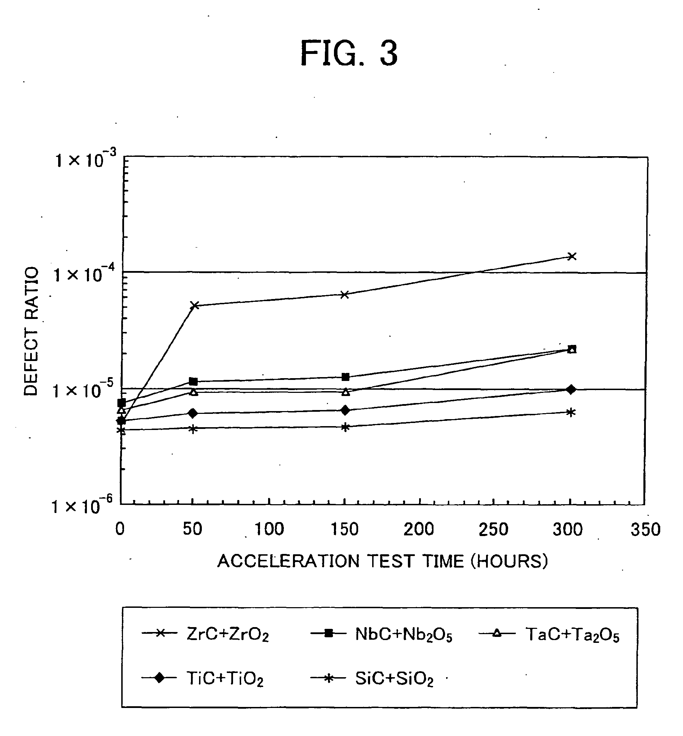

The time taken between the layer forming process and the initial crystallization process and the occurrence of defects such as allochroism, float and detachment immediately after the initial crystallization process were checked. The results are shown in Table 9. After the layer forming process, the progress of the defect ratio of the disc which was initially crystallized at a normal timing, i.e., about 24 hours later, was checked after the disc was preserved in a high temperature and high humidity. The results are shown in Table 10 and Fig. 3. "After 48 hours", "after 150 hours" and "after 300 hours" represent after an acceleration test in which an optical recording medium had been preserved for 48 hours, 150 hours or 300 hours in a high temperature and high humidity environment of 80 °C and 85 %RH. In Table 10 and Fig. 3, "E-06", etc. represent "1 x 10$^{-6}$," etc.

As seen in Table 9, defects such as allochroism, float and detachment of the sputtered layer were not observed for the discs of Examples 4 to 6. In contrast, for the disc of Comparative Example 3 in which ZrC + ZrO$_2$ was used, float of the sputtered layer was observed in the initial crystallization process after the 48 hour acceleration test. Also for the disc of Comparative Example 4 in which SiC + SiO$_2$ was used, black spots, i.e., allochroism of the sputtered layer, were observed in the recording layer in the initial crystallization process of the sputtered layer performed immediately after the sputtering process. Further, when the sputtered layer was tested for detachment and decomposition, the cohesiveness in the black spot portion significantly deteriorated between the reflective layer and the sputtered layer.

As seen in Table 10 and Fig. 3, the disc of Comparative Example 3 in which ZrC + ZrO$_2$ was used, the defect ratio thereof was relatively high compared with that of the other discs and significantly increased as the thickness of the intermediate layer increased.

Table 9

| | Target material for intermediate layer | Layer thickness (nm) | Timing of initial crystallization process after layer forming process | | | | |
|---|---|---|---|---|---|---|---|
| | | | Immediately after | 3 days after | 9 days after | After 48 hours | After 150 hours |
| Example 4 | TiC + TiO$_2$ | 2 | none | none | none | none | none |
| | | 4 | none | none | none | none | none |
| | | 8 | none | none | none | none | none |
| Example 5 | NbC + Nb$_2$O$_5$ | 2 | none | none | none | none | none |
| | | 4 | none | none | none | none | none |
| | | 8 | none | none | none | none | none |
| Example 6 | TaC + Ta$_2$O$_5$ | 2 | none | none | none | none | none |
| | | 4 | none | none | none | none | none |
| | | 8 | none | none | none | none | none |
| Comparative Example 3 | ZrC + Zr$_2$ | 2 | none | none | none | none | none |
| | | 4 | none | none | none | float | float fairly |
| | | 8 | none | none | none | float | float greatly |

(continued)

|  | Target material for intermediate layer | Layer thickness (nm) | Timing of initial crystallization process after layer forming process | | | | |
|---|---|---|---|---|---|---|---|
|  |  |  | Immediately after | 3 days after | 9 days after | After 48 hours | After 150 hours |
| comparative Example 4 | SiC + SiO$_2$ | 2 | change in color | change in color | change in color | change in color | change in color |
|  |  | 4 | change in color | change in color | change in color | change in color | change in color |
|  |  | 8 | change in color | change in color | change in color | change in color | change in color |

Table 10

|  | Target material for intermediate layer | Layer thickness (nm) | Immediately after | After 48 hours | After 150 hours | After 300 hours |
|---|---|---|---|---|---|---|
| Example 4 | TiC + TiO$_2$ | 2 | 5.44E-06 | 6.05E-06 | 5.86E-06 | 1.24E-06 |
|  |  | 4 | 5.23E-06 | 6.12E-06 | 6.53E-06 | 9.93E-06 |
|  |  | 8 | 5.54E-06 | 5.57E-06 | 5.69E-06 | 7.60E-06 |
| Example 5 | NbC + Nb$_2$O$_5$ | 2 | 5.35E-06 | 6.24E-06 | 6.42E-06 | 1.22E-06 |
|  |  | 4 | 7.27E-06 | 1.14E-06 | 1.26E-06 | 2.21E-06 |
|  |  | 8 | 7.20E-06 | 7.78E-06 | 7.83E-06 | 1.13E-06 |
| Example 6 | TaC + Ta$_2$O$_5$ | 2 | 6.36E-06 | 7.13E-06 | 7.97E-06 | 1.81E-06 |
|  |  | 4 | 6.59E-06 | 9.46E-06 | 9.47E-06 | 2.20E-06 |
|  |  | 8 | 1.42E-06 | 1.56E-06 | 1.61E-06 | 2.54E-06 |
| Comparative Example 3 | ZrC + Zr$_2$ | 2 | 5.21E-06 | 5.15E-06 | 5.76E-06 | 1.85E-06 |
|  |  | 4 | 4.80E-06 | 5.26E-06 | 6.66E-06 | 1.43E-06 |
|  |  | 8 | 4.86E-06 | 6.86E-06 | 9.54E-06 | Not measurable |
| Comparative Example 4 | SiC + SiO$_2$ | 2 | 4. 64E-06 | 4.70E-06 | 4.90E-06 | 8.03E-06 |
|  |  | 4 | 4.23E-06 | 4.59E-06 | 4.71E-06 | 6.56E-06 |
|  |  | 8 | 5.43E-06 | 5.77E-06 | 5.87E-06 | 8.54E-06 |

Examples 7 and 8

A polycarbonate substrate was prepared by projection molding. The polycarbonate substrate had a thickness of 0.6 mm and a guide groove having a groove width of 0.25 $\mu$m, a groove depth of 27 nm and a wobbling cycle of 4.26 $\mu$m. After leaving the polycarbonate substrate for 10 minutes at room temperature, a bottom protective layer, an interface layer, an optical recording layer, a top protective layer, an intermediate layer and an optical reflective layer were accumulated on the polycarbonate substrate by a sputtering method in this order.

The bottom protective layer was formed of $(ZnS)_{80}(SiO_2)_{20}$ (mol %) having a thickness of 55 nm. The interface layer was formed of $SiO_2$ having a thickness of 4 nm. The optical recording layer was formed of $Ge_8Ga_6Sb_{68}Sn_{18}$ having a thickness of 11 nm. The top protective layer was formed of $(ZnS)_{80}(SiO_2)_{20}$ (mol %) having a thickness of 8 nm. As for the intermediate layer, $Ti_{45}C_{33}O_{22}$ and $Ti_{44}C_{26}O_{30}$ having a thickness of 6 nm were used in Example 7 and Example 8, respectively. As for the optical reflective layer, Ag having a purity of 99.5 % by weight with Cu in an amount of 0.5 % by weight having a thickness of 140 nm was used.

That is, the layer structure obtained was: the polycarbonate substrate; $(ZnS)_{80}(SiO_2)_{20}$ (mol %) having a thickness of 55 nm; $SiO_2$ having a thickness of 4 nm; $Ge_8Ga_6Sb_{68}Sn_{18}$ having a thickness of 11 nm; $(ZnS)_{80}(SiO_2)_{20}$ (mol %) having a thickness of 8 nm; $Ti_{45}C_{33}O_{22}$ (Example 7) and $Ti_{44}C_{26}O_{30}$ (Example 8) having a thickness 4 nm; and Ag having a purity of 99.5 % by weight with Cu in an amount of 0.5 % by weight having a thickness of 140 nm.

The layer forming conditions of the intermediate layer were that the pressure was $5.5 \times 10^{-3}$ mbar and the sputtering speed was 2 nm/s to have a relatively low layer forming speed and increase the incident frequency of absorption gas of the substrate into the surface of the layer.

Next, an ultraviolet setting resin (SD318, manufactured by Dainippon Ink and Chemicals Incorporated) having a viscosity of 120 cps at room temperature and a glass transition temperature of 149 °C after setting was spin-coated on the optical reflective layer to form a resin protective layer. A single plate disc of a phase change type optical recording medium was thus obtained.

Further, a polycarbonate attachment substrate was bonded to the single plate disc obtained with an ultraviolet setting adhesive (DVD003 manufactured by Nippon Kayaku Co., Ltd.) having a viscosity of 450 cps at room temperature and a glass transition temperature of 75 °C after setting to obtain a phase change type optical recording medium.

Next, the optical recording layer was totally crystallized from inner to outer of the disc by an initialization device manufactured by Hitachi Computer Peripherals Co., Ltd. having a large aperture LD (beam diameter: 75 $\mu$m x 1 $\mu$m) with a constant linear velocity, i.e., 20 m/s, a power of 1, 600 mW and a sending pitch of 45 $\mu$m/r. Detachment of Ag did not occur by initialization. When the interface layer was analyzed by X-ray Photoelectron Spectroscopy (XPS), the spectra inferred to be for Ti-O and Ti-C were obtained.

Next, the phase change type optical recording medium was overwritten with a linear recording velocity of 28 m/s, a wave length of 657 nm, a numeric aperture of 0.65 and a recording power of from 32 to 38 mW in a DVD-ROM playable format using an optical disc drive device DDU-1000 manufactured by Pulstec Industrial Co., Ltd. The results were good for the discs of Examples 7 and 8. The jitter was not greater than 9 % even when overwriting was performed not less than 2,000 times.

Next, these recorded phase change type optical recording media did not deteriorate after the recorded phase change type optical recording media had been preserved for 300 hours at 80 °C and 85 %RH. When these recorded phase change type optical recording media were observed by transmission electron microscope (TEM) method, the result of the electron diffraction of the intermediate layer indicated the halo pattern of amorphous. When the surface of the optical reflective layer was observed with a scanning electron microscope (SEM), Ag crystalline particles had a particle diameter of 0.12 $\mu$m on average and still 0.12 $\mu$m after the disc had been preserved at 80 °C and 85 % RH for 300 hours, resulting in good reliability. Therefore, playback signals having a small noise were obtained and the number of errors did not increase.

Further, the recorded phase change type optical recording media were totally reinitialized from inner to outer of the media by an initialization device mentioned above manufactured by Hitachi Computer Peripherals Co., Ltd. with a constant linear velocity, i.e., 20 m/s, a power of 1,600 mW and a sending pitch of 45 $\mu$m/r. It was possible to overwrite the reinitialized optical recording media in a DVD-ROM playable format, meaning that the media can be used for recycle.

Example 9

A polycarbonate substrate was prepared by projection molding. The polycarbonate substrate had a thickness of 0.6 mm and a guide groove having a groove width of 0.25 $\mu$m, a groove depth of 27 nm and a wobbling cycle of 4.26 nm. After leaving the polycarbonate substrate for 10 minutes at room temperature, a bottom protective layer, an interface layer, an optical recording layer, a top protective layer, an intermediate layer and an optical reflective layer were accumulated on the polycarbonate substrate by a sputtering method in this order. The bottom protective layer was formed of $(ZnS)_{80}(SiO_2)_{20}$ (mol %) having a thickness of 55 nm. The interface layer was formed of $(ZrO_2)_{80}(TiO_2)_{20}$ (mol %) having a thickness of 4 nm. The optical recording layer was formed of $Ag_1Ge_3In_3Sb_{72}Te_{21}$ having a thickness of 11 nm. The top protective layer was formed of $(ZnS)_{80}(SiO_2)_{20}$ (mol %) having a thickness of 12nm. As for the intermediate layer, $Ti_{22}Nb_{22}C_{20}O_{36}$ having a thickness of 6 nm was used. As for the optical reflective layer, Ag having a purity of 99.5 % by weight with Cu in an amount of 0.5 % by weight having a thickness of 140 nm was used.

That is, the layer structure obtained was: the polycarbonate substrate; $(ZnS)_{80}(SiO_2)_{20}$ (mol %) having a thickness of 55 nm; $(ZrO_2)_{80}(TiO_2)_{20}$ (mol %) having a thickness of 4 nm; $Ag_1Ge_3In_3Sb_{72}Te_{21}$ having a thickness of 11 nm; $(ZnS)_{80}(SiO_2)_{20}$ (mol %) having a thickness of 12 nm; $Ti_{22}Nb_{22}C_{20}O_{36}$ having a thickness of 6 nm; and Ag having a purity of 99.5 % by weight with Cu in an amount of 0.5 % by weight having a thickness of 140 nm.

The layer forming conditions of the intermediate layer were that the pressure was $5.5 \times 10^{-3}$ mbar and the sputtering speed was 2 nm/s to have a relatively low layer forming speed and increase the incident frequency of absorption gas of the substrate into the surface of the layer.

Next, an ultraviolet setting resin (SD318, manufactured by Dainippon Ink and Chemicals Incorporated) having a viscosity of 120 cps at room temperature and a glass transition temperature of 149 °C after setting was spin-coated on the optical reflective layer to form a resin protective layer. Thus a single plate disc of a phase change type optical recording medium was obtained.

Further, a polycarbonate attachment substrate was bonded to the single plate disc obtained with an ultraviolet setting adhesive (DVD003 manufactured by Nippon Kayaku Co., Ltd.) having a viscosity of 450 cps at room temperature and a glass transition temperature of 75 °C after setting to obtain a phase change type optical recording medium.

Next, the optical recording layer was totally crystallized from inner to outer of the disc by an initialization device manufactured by Hitachi Computer Peripherals Co., Ltd. having a large aperture LD (beam diameter: 75 μm x 1 μm) with a constant linear velocity, i.e., 11 m/s, a power of 1, 200 mW and a sending pitch of 36 μm/r. Detachment of Ag did not occur by initialization. When the interface layer was analyzed by X-ray Photoelectron Spectroscopy (XPS), the spectra inferred to be for Ti-O, Ti-C, Nb-C and Nb-O were obtained.

Next, the phase change type optical recording medium was overwritten with a linear recording velocity of 14 m/s, a wave length of 657 nm, a numeric aperture of 0.65 and a recording power of from 17 to 22 mW in a DVD-ROM playable format using an optical disc drive device DDU-1000 manufactured by Pulstec Industrial Co., Ltd. The results were good for the discs of Examples 9. The jitter was not greater than 9 % when overwriting was performed not less than 2,000 times.

Next, these recorded phase change type optical recording media did not deteriorate after the recorded phase change type optical recording media had been preserved for 300 hours at 80 °C and 85 %RH. When these recorded phase change type optical recording media were observed by transmission electron microscope (TEM) method, the result of the electron diffraction of the intermediate layer indicated the halo pattern of amorphous. When the surface of the optical reflective layer was observed with a scanning electron microscope (SEM), Ag crystalline particles had a particle diameter of 0.12 μm on average and still 0.12 μm after the disc had been preserved at 80 °C and 85 % RH for 300 hours, resulting in good reliability. Therefore, playback signals having a small noise were obtained and the number of errors did not increase.

Further, the recorded phase change type optical recording media were totally reinitialized from inner to outer of the media by an initialization device mentioned above manufactured by Hitachi Computer Peripherals Co., Ltd. with a constant linear velocity, i.e., 10 m/s, a power of 1,200 mW and a sending pitch of 36 μm/r. It was possible to overwrite the reinitialized optical recording media in a DVD-ROM playable format, meaning that the media can be used for recycle.

This document claims priority and contains subject matter related to Japanese Patent Applications Nos. 2004-146200 and 2004344215, filed on May 17, 2004, and November 29, 2004, respectively.

[Effects of the Invention].

According to the present invention, an optical recording medium which has a good preservation reliability under a high temperature and high humidity environment, shows a stable performance at a high temperature, has good mechanical characteristics with good productivity and can optically record information with a high speed and a high density can be provided.

**Claims**

1. An optical recording medium comprising:

> a substrate (1);
> a bottom protective layer (2) located overlying the substrate (1);
> an optical recording layer (4) located overlying the bottom protective layer (2);
> a top protective layer (6) located overlying the optical recording layer (4);
> an intermediate layer (7) located overlying the top protective layer (6), comprising carbon and at least one element (M) selected from the group consisting of Ti, Nb and Ta;
> an optical reflective layer (8) comprising Ag in an amount not less than 95 atomic %, located overlying the intermediate layer (7),

wherein the optical recording medium is recordable even in one of the following recording conditions (1) to (3):

> (1) when the recording time for the shortest recording mark is not greater than 34 ns;
> (2) when the recording time of a channel bit length is not greater than 11 ns; and

(3) when the recording linear velocity is not less than 11 m/s;

**characterized in that** the intermediate layer (7) further comprises oxygen.

2. The optical recording medium according to Claim 1, wherein the intermediate layer comprises at least one of chemical linkages of (M) and carbon and (M) and oxygen.

3. The optical recording medium according to Claim 1 or 2, wherein the intermediate layer (7) comprises one combination selected from the group consisting of (A) Ti, C and O, (B) Nb, C and O, and (C) Ta, C and O, wherein composition ratios of Ti, C and O in (A) satisfy the following relationships:

$$37 \leq \alpha1 \leq 48$$

$$12 \leq \beta1 \leq 45$$

$$7 \leq \gamma1 \leq 51$$

$$\alpha1 + \beta1 + \gamma1 = 100,$$

wherein $\alpha1$, $\beta1$ and $\gamma1$ represent a composition ratio by atomic % of Ti, C and O, respectively, composition ratios of Nb, C and O in (B) satisfy the following relationships:

$$33 \leq \alpha2 \leq 47$$

$$9 \leq \beta2 \leq 43$$

$$10 \leq \gamma2 \leq 58$$

$$\alpha2 + \beta2 + \gamma2 = 100,$$

wherein $\alpha2$, $\beta2$ and $\gamma2$ represent a composition ratio by atomic % of Nb, C and O, respectively, and composition ratios of Ta, C and O in (C) satisfy the following relationships:

$$32 \leq \alpha3 \leq 47$$

$$9 \leq \beta3 \leq 43$$

$$10 \leq \gamma 3 \leq 59$$

$$\alpha 3 + \beta 3 + \gamma 3 = 100,$$

wherein $\alpha 3$, $\beta 3$ and $\gamma 3$ represent a composition ratio by atomic % of Ta, C and O, respectively.

4. The optical recording medium according to any one of Claims 1 to 3, wherein the intermediate layer (7) has a thickness of from 1 to 9 nm.

5. The optical recording medium according to any one of Claims 1 to 4, wherein the top protective layer (6) comprises ZnS and $SiO_2$.

6. The optical recording medium according to any one of Claims 1 to 5, wherein the recording layer (4) comprises an alloyed metal selected from the group consisting of a structural formula (A) represented by $Ag_\alpha Ge_\beta In_\gamma Sb_\delta Te_\varepsilon$ and a structural formula (B) having a structural formula represented by $Ga_{\alpha'1}In_{\alpha'2}Ge_\beta Sb_\gamma Sn_\delta Bi_{\varepsilon'1}Te_{\varepsilon'2}$.
   wherein the structural formula (A) satisfies the following relationships:

$$0 \leq \alpha \leq 5$$

$$0 \leq \beta \leq 5$$

$$2 \leq \gamma \leq 10$$

$$60 \leq \delta \leq 90$$

$$15 \leq \varepsilon \leq 30$$

$$\alpha + \beta + \gamma + \delta + \varepsilon = 100,$$

wherein $\alpha$, $\beta$, $\gamma$, $\delta$ and $\varepsilon$ represent atomic %, and
the structural formula (B) satisfies the following relationships:

$$0 \leq \alpha' 1 \leq 20$$

$$0 \leq \alpha' 2 \leq 20$$

$$2 \leq \alpha' 1 + \alpha' 2 \leq 20$$

$$2 \leq \beta' \leq 20$$

$$60 \leq \gamma' \leq 90$$

$$5 \leq \delta' \leq 25$$

$$0 \leq \varepsilon'1 \leq 10$$

$$0 \leq \varepsilon'2 \leq 10$$

$$0 \leq \varepsilon'1 + \varepsilon'2 \leq 10$$

$$\alpha'1 + \alpha'2 + \beta' + \gamma' + \delta' + \varepsilon'1 + \varepsilon'2 = 100,$$

wherein $\alpha'1$, $\alpha'2$, $\beta'$, $\gamma'$, $\delta'$, $\varepsilon'1$ and $\varepsilon'2$ represent atomic %.

7. The optical recording medium according to any one of Claims 1 to 6, wherein the optical recording medium is recyclable for use by irradiating the optical recording layer (4) with a semiconductor laser beam for re-crystallization of the optical recording medium.

8. A method of manufacturing an optical recording medium according to claim 1 said method comprising:

initially crystallizing the optical recording medium; and
randomly inspecting the optical recording medium for an appearance, the number of errors and defect ratio thereof to evaluate quality of the optical recording medium and quality of manufacturing process of the optical recording medium,

said method further comprising
storing an optical recording medium at 85% RH (relative humidity) and 80°C before initially crystallizing the optical recording medium.

9. A sputtering target for forming an intermediate layer (7) of an optical recording medium, comprising:

one combination selected from the group consisting of (A) TiC and $TiO_2$, (B) NbC and $Nb_2O_5$, and (C) TaC and $Ta_2O_5$,

**characterized in that** the composition ratios of Ti, C and O in (A) satisfy the following relationship:

$$37 \leq \alpha1 \leq 48$$

$$12 \leq \beta1 \leq 45$$

$$7 \le \gamma_1 \le 51$$

$$\alpha_1 + \beta_1 + \gamma_1 = 100,$$

wherein $\alpha_1$, $\beta_1$ and $\gamma_1$ represent a composition ratio by atomic % of Ti, C and O, respectively, composition ratios of Nb, C and O in (B) satisfy the following relationship:

$$33 \le \alpha_2 \le 47$$

$$9 \le \beta_2 \le 43$$

$$10 \le \gamma_2 \le 58$$

$$\alpha_2 + \beta_2 + \gamma_2 = 100,$$

wherein $\alpha_2$, $\beta_2$ and $\gamma_2$ represent a composition ratios by atomic % of Nb, C and O, respectively, and composition ratios of Ta, C and O in (C) satisfy the following relationships:

$$32 \le \alpha_3 \le 47$$

$$9 \le \beta_3 \le 43$$

$$10 \le \gamma_3 \le 59$$

$$\alpha_3 + \beta_3 + \gamma_3 = 100,$$

wherein $\alpha_3$, $\beta_3$ and $\gamma_3$ represent a composition ratio by atomic % of Ta, C and O, respectively.

**Patentansprüche**

1. Optisches Aufzeichnungsmedium, umfassend:

   ein Substrat (1);
   eine untere Schutzschicht (2), die sich über dem Substrat (1) befindet,
   eine optische Aufzeichnungsschicht (4), die sich über der unteren Schutzschicht (2) befindet;
   eine obere Schutzschicht (6), die sich über der optischen Aufzeichnungsschicht (4) befindet;
   eine Zwischenschicht (7), die sich über der oberen Schutzschicht (6) befindet, umfassend Kohlenstoff und mindestens ein Element (M) ausgewählt aus der Gruppe bestehend aus Ti, Nb und Ta;
eine optische Reflexionsschicht (8), umfassend Ag in einer Menge von nicht weniger als 95 Atom-%, die sich über der Zwischenschicht (7) befindet,

wobei das optische Aufzeichnungsmedium selbst bei einer der folgenden Aufzeichnungsbedingungen (1) bis (3) aufzeichenbar ist:

(1) wenn die Aufzeichnungszeit für die kürzeste Aufzeichnungsmarkierung nicht größer als 34 ns ist;
(2) wenn die Aufzeichnungszeit einer Kanal-Bitlänge nicht größer als 11 ns ist; und
(3) wenn die lineare Aufzeichnungsgeschwindigkeit nicht weniger als 11 m/s ist;

**dadurch gekennzeichnet, dass** die Zwischenschicht (7) ferner Sauerstoff umfasst.

2. Optisches Aufzeichnungsmedium nach Anspruch 1, wobei die Zwischenschicht mindestens eine von chemischen Verknüpfungen von (M) und Kohlenstoff und (M) und Sauerstoff umfasst.

3. Optisches Aufzeichnungsmedium nach Anspruch 1 oder 2, wobei die Zwischenschicht (7) eine Kombination ausgewählt aus der Gruppe bestehend aus (A) Ti, C und O, (B) Nb, C und O und (C) Ta, C und O umfasst, wobei die Zusammensetzungsverhältnisse von Ti, C und O in (A) die folgenden Beziehungen erfüllen:

$$37 \leq \alpha1 \leq 48$$

$$12 \leq \beta1 \leq 45$$

$$7 \leq \gamma1 \leq 51$$

$$\alpha1 + \beta1 + \gamma1 = 100,$$

worin $\alpha1$, $\beta1$ und $\gamma1$ ein Zusammensetzungsverhältnis bezogen auf Atom-% von Ti, C bzw. O darstellen, die Zusammensetzungsverhältnisse von Nb, C und O in (B) die folgenden Beziehungen erfüllen:

$$33 \leq \alpha2 \leq 47$$

$$9 \leq \beta2 \leq 43$$

$$10 \leq \gamma2 \leq 58$$

$$\alpha2 + \beta2 + \gamma2 = 100,$$

worin $\alpha2$, $\beta2$ und $\gamma2$ ein Zusammensetzungsverhältnis bezogen auf Atom-% von Nb, C bzw. O darstellen, und die Zusammensetzungsverhältnisse von Ta, C und O in (C) die folgenden Beziehungen erfüllen:

$$32 \leq \alpha3 \leq 47$$

$$9 \leq \text{ß}3 \leq 43$$

$$10 \leq \gamma3 \leq 59$$

$$\alpha3 + \text{ß}3 + \gamma3 = 100,$$

worin $\alpha3$, $\beta3$ und $\gamma3$ ein Zusammensetzungsverhältnis bezogen auf Atom-% von Ta, C bzw. O darstellen.

4. Optisches Aufzeichnungsmedium nach irgendeinem der Ansprüche 1 bis 3,
   wobei die Zwischenschicht (7) eine Dicke von 1 bis 9 nm aufweist.

5. Optisches Aufzeichnungsmedium nach irgendeinem der Ansprüche 1 bis 4,
   wobei die obere Schutzschicht (6) ZnS und $SiO_2$ umfasst.

6. Optisches Aufzeichnungsmedium nach irgendeinem der Ansprüche 1 bis 5,
   wobei die Aufzeichnungsschicht (4) eine Metalllegierung ausgewählt aus der Gruppe bestehend aus einer Strukturformel (A) dargestellt durch $Ag_\alpha Ge_\beta In_\gamma Sb_\delta Te_\varepsilon$ und einer Strukturformel (B) mit einer Strukturformel dargestellt
   durch $Ga_{\alpha'1} In_{\beta'2} Ge_{\beta'} Sb_{\gamma'} Sn_{\delta'} Bi_{\varepsilon'1} Te_{\varepsilon'2}$ umfasst,
   wobei die Strukturformel (A) die folgenden Beziehungen erfüllt:

$$0 \leq \alpha \leq 5$$

$$0 \leq \text{ß} \leq 5$$

$$2 \leq \gamma \leq 10$$

$$60 \leq \delta \leq 90$$

$$15 \leq \varepsilon \leq 30$$

$$\alpha + \text{ß} + \gamma + \delta + \varepsilon = 100$$

worin $\alpha$, $\beta$, $\gamma$, $\delta$ und $\varepsilon$ Atom-% darstellen, und
die Strukturformel (B) die folgenden Beziehungen erfüllt:

$$0 \leq \alpha'1 \leq 20$$

$$0 \leq \alpha'2 \leq 20$$

$$2 \leq \alpha'1 + \alpha'2 \leq 20$$

$$2 \leq \text{ß}' \leq 20$$

$$60 \leq \gamma' \leq 90$$

$$5 \leq \delta' \leq 25$$

$$0 \leq \varepsilon'1 \leq 10$$

$$0 \leq \varepsilon'2 \leq 10$$

$$0 \leq \varepsilon'1 + \varepsilon'2 \leq 10$$

$$\alpha'1 + \alpha'2 + \text{ß}' + \gamma' + \delta' + \varepsilon' + \varepsilon'2 = 100,$$

worin $\alpha'1$, $\alpha'2$, $\beta'$, $\gamma'$, $\delta'$, $\varepsilon'1$ und $\varepsilon'2$ Atom-% darstellen.

**7.** Optisches Aufzeichnungsmedium nach irgendeinem der Ansprüche 1 bis 6,
wobei das optische Aufzeichnungsmedium durch Bestrahlen der optischen Aufzeichnungsschicht (4) mit einem Halbleiterlaserstrahl zur Rekristallisation des optischen Aufzeichnungsmediums für den Einsatz wiederverwendbar ist.

**8.** Verfahren zur Herstellung eines optischen Aufzeichnungsmediums nach Anspruch 1, wobei das Verfahren umfasst:

anfängliches Kristallisieren des optischen Aufzeichnungsmediums, und
zufälliges Prüfen des optischen Aufzeichnungsmediums nach dem Aussehen, der Anzahl von Fehlern und dem Defektanteil davon, um die Qualität des optischen Aufzeichnungsmediums und die Qualität des Herstellungsverfahrens des optischen Aufzeichnungsmediums zu bewerten,

wobei das Verfahren ferner das Lagern eines optischen Aufzeichnungsmediums bei 85% r.F. (relative Feuchtigkeit) und 80°C vor dem anfänglichen Kristallisieren des optischen Aufzeichnungsmediums umfasst.

**9.** Sputtertarget zur Bildung einer Zwischenschicht (7) von einem optischen Aufzeichnungsmedium, umfassend:

eine Kombination ausgewählt aus der Gruppe bestehend aus (A) TiC und $TiO_2$, (B) NbC und $Nb_2O_5$ und (C) TaC und $Ta_2O_5$,

**dadurch gekennzeichnet, dass** die Zusammensetzungsverhältnisse von Ti, C und O in (A) die folgende Beziehung erfüllen:

$$37 \leq \alpha1 \leq 48$$

$$12 \leq \text{ß1} \leq 45$$

$$7 \leq \gamma1 \leq 51$$

$$\alpha1 + \text{ß1} + \gamma1 = 100,$$

worin $\alpha1$, $\beta1$ und $\gamma1$ ein Zusammensetzungsverhältnis bezogen auf Atom-% von Ti, C bzw. O darstellen, die Zusammensetzungsverhältnisse von Nb, C und O in (B) die folgende Beziehung erfüllen:

$$33 \leq \alpha2 \leq 47$$

$$9 \leq \text{ß2} \leq 43$$

$$10 \leq \gamma2 \leq 58$$

$$\alpha2 + \text{ß2} + \gamma2 = 100,$$

worin $\alpha2$, $\beta2$ und $\gamma2$ Zusammensetzungsverhältnisse bezogen auf Atom-% von Nb, C bzw. O darstellen, und die Zusammensetzungsverhältnisse von Ta, C und O in (C) die folgenden Beziehungen erfüllen:

$$32 \leq \alpha3 \leq 47$$

$$9 \leq \text{ß3} \leq 43$$

$$10 \leq \gamma3 \leq 59$$

$$\alpha3 + \text{ß3} + \gamma3 = 100,$$

worin $\alpha3$, $\beta3$ und $\gamma3$ ein Zusammensetzungsverhältnis bezogen auf Atom-% von Ta, C bzw. O darstellen.

**Revendications**

1. Support d'enregistrement optique comprenant :

   un substrat (1) ;
   une couche de protection inférieure (2) disposée sur le substrat (1) ;
   une couche d'enregistrement optique (4) disposée sur la couche de protection inférieure (2)
   une couche de protection supérieure (6) disposée sur la couche d'enregistrement optique (4) ;

une couche intermédiaire (7) disposée sur la couche protectrice supérieure (6), comprenant du carbone et au moins un élément (M) choisi dans le groupe constitué de Ti, Nb et Ta ;
une couche de réflexion optique (8) comprenant Ag en une quantité non inférieure à 95 % atomique, disposée sur la couche intermédiaire (7),

dans lequel le milieu d'enregistrement optique est enregistrable même dans une des conditions d'enregistrement suivantes (1) à (3) :

(1) le temps d'enregistrement de la marque d'enregistrement la plus courte n'est pas supérieur à 34 ns ;
(2) le temps d'enregistrement d'une longueur binaire du canal n'est pas supérieur à 11 ns ; et
(3) la vitesse d'enregistrement linéaire n'est pas inférieure à 11 m/s ; **caractérisé en ce que** la couche intermédiaire (7) comprend en outre de l'oxygène.

2.  Milieu d'enregistrement optique selon la revendication 1, dans lequel la couche intermédiaire comprend au moins une des liaisons chimiques entre (M) et le carbone et entre (M) et l'oxygène.

3.  Milieu d'enregistrement optique selon l'une quelconque des revendications 1 à 2, dans lequel la couche intermédiaire (7) comprend une combinaison choisie dans le groupe constitué de (A) Ti, C et O, (B) Nb, C et O, et (C) Ta, C et O, dans lequel les rapports de composition de Ti, C et O dans (A) satisfont les relations suivantes :

$$37 \leq \alpha_1 \leq 48$$

$$12 \leq \beta_1 \leq 45$$

$$7 \leq \gamma_1 \leq 51$$

$$\alpha_1 + \beta_1 + \gamma_1 = 100,$$

dans lesquelles $\alpha_1$, $\beta_1$ et $\gamma_1$ représentent un rapport de composition en % atomique respectivement de Ti, C et O, les rapports de composition de Nb, C et O dans (B) satisfont les relations suivantes :

$$33 \leq \alpha_2 \leq 47$$

$$9 \leq \beta_2 \leq 43$$

$$10 \leq \gamma_2 \leq 58$$

$$\alpha_2 + \beta_2 + \gamma_2 = 100,$$

dans lesquelles $\alpha_2$, $\beta_2$ et $\gamma_2$ représentent un rapport de composition en % atomique respectivement de Nb, C et O, et les rapports de composition de Ta, C et O dans (C) satisfont les relations suivantes :

$$32 \leq \alpha_3 \leq 47$$

$$9 \leq \beta3 \leq 43$$

$$10 \leq \gamma3 \leq 59$$

$$\alpha3 + \beta3 + \gamma3 = 100,$$

dans lesquelles $\alpha3$, $\beta3$ et $\gamma3$ représentent un rapport de composition en % atomique respectivement de Ta, C et O.

4. Milieu d'enregistrement optique selon l'une quelconque des revendications 1 à 3, dans lequel la couche intermédiaire (7) a une épaisseur de 1 à 9 nm.

5. Milieu d'enregistrement optique selon l'une quelconque des revendications 1 à 4, dans lequel la couche protectrice supérieure (6) comprend ZnS et $SiO_2$.

6. Milieu d'enregistrement optique selon l'une quelconque des revendications 1 à 5, dans lequel la couche d'enregistrement (4) comprend un métal allié choisi dans le groupe constitué d'une formule structurale (A) représentée par $Ag_\alpha Ge_\beta In_\gamma Sb_\delta Te_\varepsilon$ et d'une formule structurale (B) représentée par $Ga_{\alpha'1} In_{\alpha'2} Ge_\beta, Sb_\gamma, Sn_\delta, Bi_{\varepsilon'1} Te_{\varepsilon'2}$,
dans lequel la formule structurale (A) satisfait les relations suivantes :

$$0 \leq \alpha \leq 5$$

$$0 \leq \beta \leq 5$$

$$2 \leq \gamma \leq 10$$

$$60 \leq \delta \leq 90$$

$$15 \leq \varepsilon \leq 30$$

$$\alpha + \beta + \gamma + \delta + \varepsilon = 100,$$

dans lesquelles $\alpha$, $\beta$, $\gamma$, $\delta$ et $\varepsilon$ représentent des % atomiques, et
la formule structurale (B) satisfait les relations suivantes :

$$0 \leq \alpha'1 \leq 20$$

$$0 \leq \alpha'2 \leq 20$$

$$2 \leq \alpha'1 \leq \alpha'2 \leq 20$$

$$2 \le \beta' \le 20$$

$$60 \le \gamma' \le 90$$

$$5 \le \delta' \le 25$$

$$0 \le \varepsilon'1 \le 10$$

$$0 \le \varepsilon'2 \le 10$$

$$0 \le \varepsilon'1 \le \varepsilon'2 \le 10$$

$$\alpha'1 + \alpha'2 + \beta' + \gamma' + \delta' + \varepsilon'1 + \varepsilon'2 = 100,$$

dans lesquelles $\alpha'1$, $\alpha'2$, $\beta'$, $\gamma'$, $\delta'$, $\varepsilon'1$ et $\varepsilon'2$ représentent des % atomiques.

7. Milieu d'enregistrement optique selon l'une quelconque des revendications 1 à 6, dans lequel le milieu d'enregistrement optique est recyclable pour une utilisation en irradiant la couche d'enregistrement optique (4) avec un faisceau laser semi-conducteur pour une recristallisation du milieu d'enregistrement optique.

8. Procédé de fabrication d'un support d'enregistrement optique selon la revendication 1, ledit procédé comprenant l'étape consistant à :

initialement cristalliser le milieu d'enregistrement optique ; et examiner avec soin et de manière aléatoire le milieu d'enregistrement optique en ce qui concerne son apparence, le nombre d'erreurs et le taux de défauts de celui-ci afin d'évaluer la qualité du milieu d'enregistrement optique et la qualité du procédé de fabrication du milieu d'enregistrement optique, ledit procédé comprenant en outre l'étape consistant à :

stocker le support d'enregistrement optique à 85 % de HR (d'humidité relative) et 80°C avant de cristalliser initialement le milieu d'enregistrement optique.

9. Cible de pulvérisation destinée à la formation d'une couche intermédiaire (7) d'un support d'enregistrement optique, comprenant :

une combinaison choisie dans le groupe constitué de (A) TiC et $TiO_2$, de (B) NbC et $Nb_2O_5$, et de (C) TaC et $Ta_2O_5$,

**caractérisé en ce que** les rapports de composition de Ti, C et O dans (A) satisfont les relations suivantes :

$$37 \le \alpha1 \le 48$$

$$12 \le \beta1 \le 45$$

$$7 \leq \gamma1 \leq 51$$

$$\alpha1 + \beta1 + \gamma1 = 100,$$

dans lesquelles $\alpha1$, $\beta1$ et $\gamma1$ représentent un rapport de composition en % atomique respectivement de Ti, C et O, les rapports de composition de Nb, C et O dans (B) satisfont les relations suivantes :

$$33 \leq \alpha2 \leq 47$$

$$9 \leq \beta2 \leq 43$$

$$10 \leq \gamma2 \leq 58$$

$$\alpha2 + \beta2 + \gamma2 = 100,$$

dans lesquelles $\alpha2$, $\beta2$ et $\gamma2$ représentent les rapports de composition en % atomique respectivement de Nb, C et O, et les rapports de composition de Ta, C et O dans (C) satisfont les relations suivantes :

$$32 \leq \alpha3 \leq 47$$

$$9 \leq \beta3 \leq 43$$

$$10 \leq \gamma3 \leq 59$$

$$\alpha3 + \beta3 + \gamma3 = 100,$$

dans lesquelles $\alpha3$, $\beta3$ et $\gamma3$ représentent un rapport de composition en % atomique respectivement de Ta, C et O.

# FIG. 1
## PRIOR ART

EFM SIGNAL

DATA 1

DATA 0

← nT →

IRRADIATION
PATTERN

Pw

Pe

Pb

RECORDING
MARK

# FIG. 2

11
10
9
8
7
6
5
4
3
2
1

# FIG. 3

ACCELERATION TEST TIME (HOURS)

Legend:
- —×— ZrC+ZrO$_2$
- —■— NbC+Nb$_2$O$_5$
- —△— TaC+Ta$_2$O$_5$
- —◆— TiC+TiO$_2$
- —*— SiC+SiO$_2$

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP S57186244 B
- JP H9156224 B
- JP 2749080 B
- JP 52002783 A
- JP 4061791 A
- JP 60179953 A
- JP 4074785 A
- JP 6090808 A
- JP 2511964 B
- JP 2915112 B
- JP 2788395 B
- JP 11238253 A
- JP 2002074746 A
- JP 10275360 A
- JP 2002203338 A
- EP 1406254 A2
- JP 9138947 A
- JP 2001250230 A
- JP 2002288828 A
- JP 2004146200 A
- JP 2004344215 B